# EUROPEAN PATENT APPLICATION

(11) **EP 4 718 474 A2**
(43) Date of publication of application: **01.04.2026**
(21) Application number: 25200513.7
(22) Date of filing: 05.09.2025
(51) Int. Cl.: G21H 1/06

(54) **INTEGRATED ISOTOPE BATTERY**

(30) Priority: 06.09.2024 KR 20240121832; 04.09.2025 KR 20250125548
(71) Applicant: LG Energy Solution, Ltd., Seoul 07335 (KR)
(72) Inventor: KIM, Dong Myung, 34122 Daejeon (KR); KIM, Je Young, 34122 Daejeon (KR); SHIN, Dong Myung, 34122 Daejeon (KR)
(74) Representative: BCKIP Part mbB

(57) **Abstract**

An integrated isotope battery comprising at least one unit battery layer is disclosed. The unit battery layer includes: a substrate having a first major surface, an opposite second major surface, and a plurality of recesses formed in the first major surface; a pattern disposed in the plurality of recesses, wherein the pattern has a conductive type opposite to a conductive type of the substrate, a p-n junction being formed between the substrate and the pattern; and a radioactive radiation source pattern disposed in the plurality of recesses, on the pattern, wherein the radioactive radiation source pattern is configured to emit radioactive radiation to an interface between the substrate and the pattern. The radioactive radiation source pattern has at least a portion with a tapered shape, gradually becoming thinner towards the second major surface.

## Description

### [Technical Field]

The present invention relates to an integrated isotope battery, and particularly, to an integrated isotope battery.

### [Background Art]

Generally, isotope batteries produce power using a radioactive isotope typically emitting beta rays, alpha rays, etc., along with semiconductor materials. For example, beta batteries (or beta-radioactive batteries) are a type of radioactive battery that produces electricity using beta decay of a radioactive isotope. Isotope batteries operate by directly converting energy emitted during radioactive decay into electric energy.

Isotope batteries are capable of continuously producing energy during the half-life of the radioactive isotope and thus the lifespan thereof is very long. In addition, isotope batteries are capable of constantly supplying power regardless of an environment and thus can be used stably even in extreme environments.

### [Summary of the Invention]

The present invention is directed to providing an integrated isotope battery showing high energy efficiency.

To this end, the present invention provides an integrated isotope battery in accordance with independent claim 1. Further preferred features are defined in dependent claims.

In accordance with the present invention, an integrated isotope battery comprises at least one unit battery layer. The unit battery layer includes: a substrate having a first major surface, an opposite second major surface, and a plurality of recesses formed in the first major surface; a pattern disposed in the plurality of recesses, wherein the pattern has a conductive type opposite to a conductive type of the substrate, a p-n junction being formed between the substrate and the pattern; and a radioactive radiation source pattern disposed in the plurality of recesses, on the pattern, wherein the radioactive radiation source pattern is configured to emit radioactive radiation to an interface between the substrate and the pattern. The radioactive radiation source pattern may have at least a portion with a tapered shape, gradually becoming thinner towards the second major surface.

Preferably, the recess may have at least a portion with a tapered shape, gradually becoming thinner towards the second major surface of the substate, being conformal with the at least a portion of the radioactive radiation source pattern.

Optionally, the plurality of radioactive radiation source pattern may have a second portion with an oppositely tapered shape, gradually becoming wider towards the second major surface of the substrate, such that the radioactive radiation source pattern has a narrow middle.

Further, the recess may have a second portion with an oppositely tapered shape, gradually becoming wider towards the second major surface of the substrate. The second portion may be conformal with the second portion of the radioactive radiation source pattern.

Furthermore, the pattern may have a uniform width throughout the thickness of the substrate.

Moreover, the plurality of recesses may extend entirely through the substrate from the first major surface till the second major surface.

Additionally, the plurality of recesses may be arranged within the first major surface in a honeycomb structure.

Besides, the plurality of recesses may be arranged within the first major surface forming multiple rows aligned in a staggering manner with respect to one another.

Optionally, the plurality of recesses may be arranged within the first major surface in a matrix.

Preferably, each of the plurality of recesses may have a longitudinal shape with an extension along the first major surface.

Exemplarily, each of the plurality of recesses may have a roughened circumference.

For example, each of the plurality of recesses may have a star-like circumference within the first major surface of the substrate.

Possibly, an interface between the substrate and the pattern may be roughened.

Further, an interface between the pattern and the radioactive radiation source pattern may be roughened.

Furthermore, the radioactive radiation source pattern may be configured to emit beta rays and/or alpha rays.

Moreover, the unit battery layer may further comprise: a scintillation pattern disposed in the plurality of recesses for emitting photons in response to alpha rays.

Preferably, the scintillation pattern may include: a lower scintillation pattern disposed in-between the pattern and the radioactive radiation source pattern; and an upper scintillation pattern disposed on top of the radioactive radiation source pattern to cover it.

More preferably, the upper scintillation pattern may form a continuous layer with the lower scintillation pattern.

The integrated isotope battery may comprise: two or more of the unit battery layer; and an insulating layer interposed between the two or more unit battery layers.

Optionally, the integrated isotope battery may further comprise a plurality of vias electrically connecting the two or more unit battery layers through the insulating layer.

The plurality of vias may connect a substrate of one of the two or more unit battery layers directly stacked on top of the other with a layer of the other of the two or more unit battery layers.

Possibly, the two or more unit battery layers may be connected in series.

For example, the two or more unit battery layers may be configured such that their respective substrates have an identical conductive type and their respective layers have an identical conductive type.

Alternatively, the two or more unit battery layers may be connected in parallel.

For example, the two unit battery layers stacked on top of the other may be configured such that their respective substrates have opposite conductive types and their respective layers have opposite conductive types.

Preferably, the integrated isotope battery may further comprise a core layer including a peripheral transistor.

Further, the at least one unit battery layer may be arranged on top of the core layer.

Besides, the peripheral transistor may include a voltage regulator configured to adjust output voltage of the at least one unit battery layers.

An integrated circuit according to the present invention includes an oblique interface between a semiconductor layer and a radioactive radiation source. Accordingly, energy efficiency of the radioactive radiation source can be improved.

Effects achievable from exemplary embodiments of the present invention are not limited to the above-described effects, and other effects that are not described herein will be clearly derived and understood based on the following description by those of ordinary skilled in the art to which the present invention pertain to. That is, unintended effects achieved when the exemplary embodiments of the present invention are implemented are derivable by those of ordinary skilled in the art from the exemplary embodiments of the present invention.

### [Brief Description of Drawings]

FIG. 1 is a flowchart of a method for manufacturing a unit battery layer of an integrated isotope battery according to the present invention.
FIG. 2 is a plan view for describing a method for manufacturing a unit battery layer of an integrated battery according to the present invention.
FIG. 3 is a cross-sectional view taken along line 2I-2I' of FIG. 2.
FIG. 4 is a plan view for describing a method for manufacturing a unit battery layer of an integrated battery according to the present invention.
FIG. 5 is a cross-sectional view taken along line 4I-4I' of FIG. 4.
FIG. 6 is a plan view for describing a method for manufacturing a unit battery layer of an integrated battery according to the present invention.
FIG. 7 is a cross-sectional view taken along line 6I-6I' of FIG. 6.
FIG. 8 is a plan view for describing a method for manufacturing a unit battery layer of an integrated battery according to the present invention.
FIG. 9 is a cross-sectional view taken along line 8I-8I' of FIG. 8.
FIG. 10 is a plan view for describing a method for manufacturing a unit battery layer of an integrated battery according to the present invention.
FIG. 11 is a cross-sectional view taken along line 10I-10I' of FIG. 10.
FIG. 12 is a cross-sectional view for describing a method for manufacturing a unit battery layer of an integrated battery according to the present invention.
FIG. 13 is a flowchart of a method for manufacturing a unit battery layer of an integrated isotope battery according to the present invention.
FIGS. 14 to 16 are diagrams for describing respective steps of a method for manufacturing a unit battery layer of an integrated isotope battery according to the present invention.
FIG. 17 is a flowchart of a method for manufacturing an integrated isotope battery according to the present invention.
FIGS. 18 to 21 are diagrams for describing a method for manufacturing an integrated isotope battery according to the present invention.
FIG. 22 is a plan view for describing a manufacturing method of an integrated isotope battery according to the present invention.
FIG. 23 is a cross-sectional view taken along line 22I-22I' of FIG. 22.
FIG. 24 is a cross-sectional view for describing a manufacturing method of an integrated isotope battery according to the present invention.
FIG. 25 is a diagram illustrating an integrated isotope battery according to the present invention.
FIG. 26 is a plan view of a unit battery layer of an integrated isotope battery according to the present invention.
FIG. 27 is a cross-sectional view taken along line 26I-26I' of FIG. 26.
FIG. 28 is a plan view of a unit battery layer of an integrated isotope battery according to the present invention.
FIG. 29 is a cross-sectional view taken along line 28I-28I' of FIG. 28.
FIG. 30 is a plan view of a unit battery layer of an integrated isotope battery according to the present invention.
FIG. 31 is a cross-sectional view taken along line 30I-30I' of FIG. 30.
FIG. 32 is a plan view of a unit battery layer of an integrated isotope battery according to the present invention.
FIG. 33 is a cross-sectional view taken along line 32I-32I' of FIG. 32.
FIG. 34 is a plan view for describing a manufacturing method of a unit battery layer of an integrated isotope battery according to the present invention.
FIG. 35 is a cross-sectional view taken along line 34I-34I' of FIG. 34.
FIG. 36 is a plan view for describing a manufacturing method of an integrated isotope battery according to the present invention.
FIG. 37 is a cross-sectional view taken along line 36I-36I' of FIG. 36.
FIG. 38 is a cross-sectional view for describing a manufacturing method of an integrated isotope battery according to the present invention. More specifically, FIG. 38 illustrates a part corresponding to FIG. 37.
FIG. 39 is a flowchart of a manufacturing method of an integrated isotope battery according to the present invention.
FIGS. 40 to 46 are diagrams for describing a manufacturing method of an integrated isotope battery according to the present invention.

### [Detailed Description of Exemplary Embodiments]

Hereinafter, embodiments of the present invention will be described in detail with reference to the accompanying drawings. Before describing embodiments of the present invention, the terms or expressions used in the present application should not be construed as being limited to as generally understood or as defined in commonly used dictionaries, and should be understood according to meanings and concepts corresponding to the present invention on the basis of the principle that the inventor(s) of the application can appropriately define the terms or expressions to optimally explain the present invention.

Therefore, embodiments set forth herein and configurations illustrated in the drawings are only examples of the present invention and do not reflect all the technical ideas of the present invention and thus it should be understood that various equivalents and modifications that replace the configurations would still fall within the scope of the claims.

Well-known configurations or functions related to describing the present invention are not described in detail when it is determined that they would obscure the subject matter of the present invention due to unnecessary detail.

Because embodiments of the present invention are provided to more fully explain the present invention to those of ordinary skill in the art, the shapes, sizes, etc. of components illustrated in the drawings may be exaggerated, omitted, or schematically illustrated for clarity. Therefore, it should not be understood that the sizes or proportions of components fully reflect the actual sizes or proportions thereof.

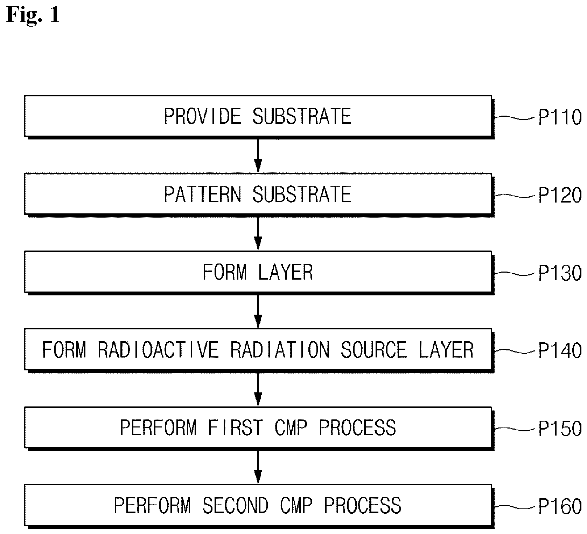

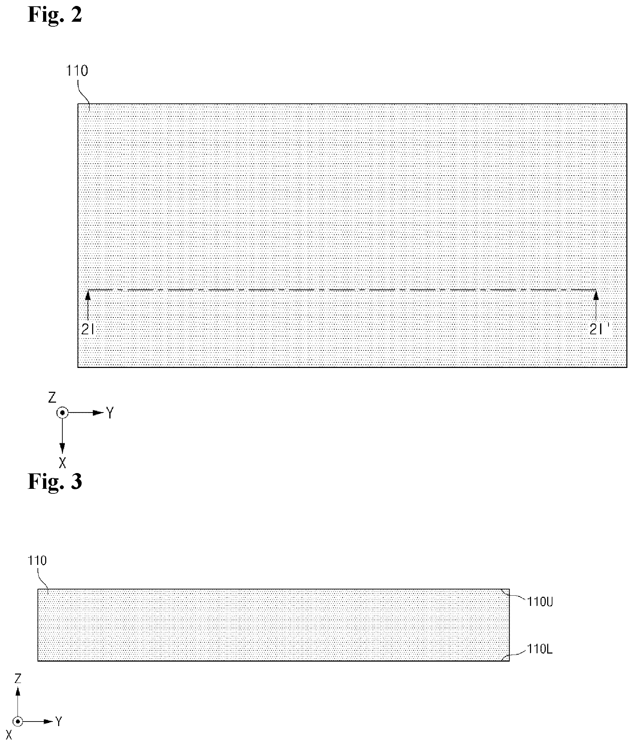

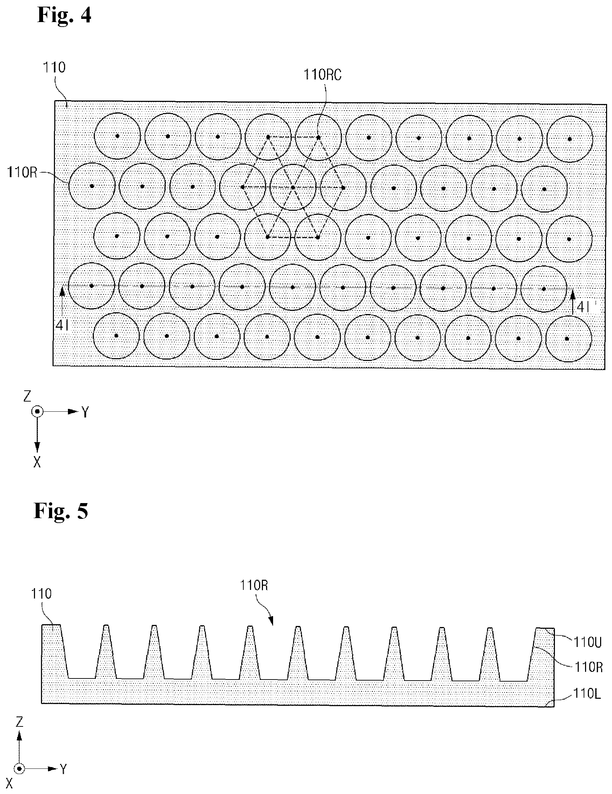

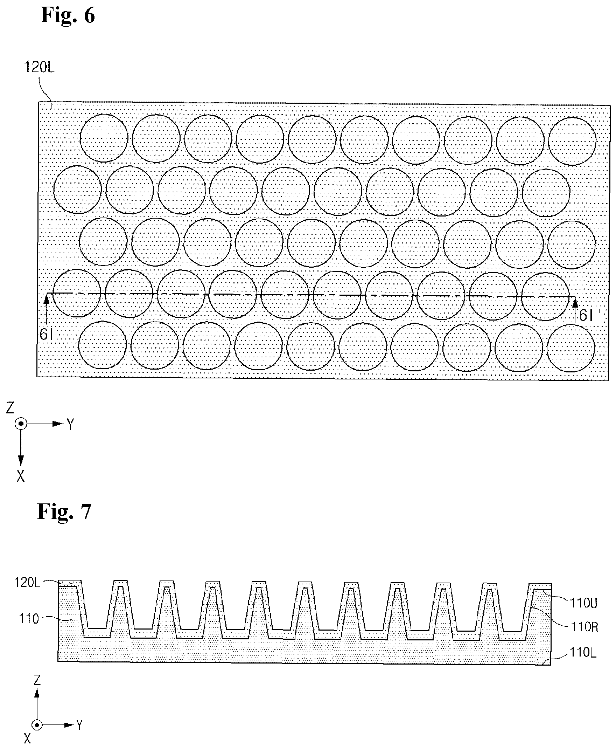

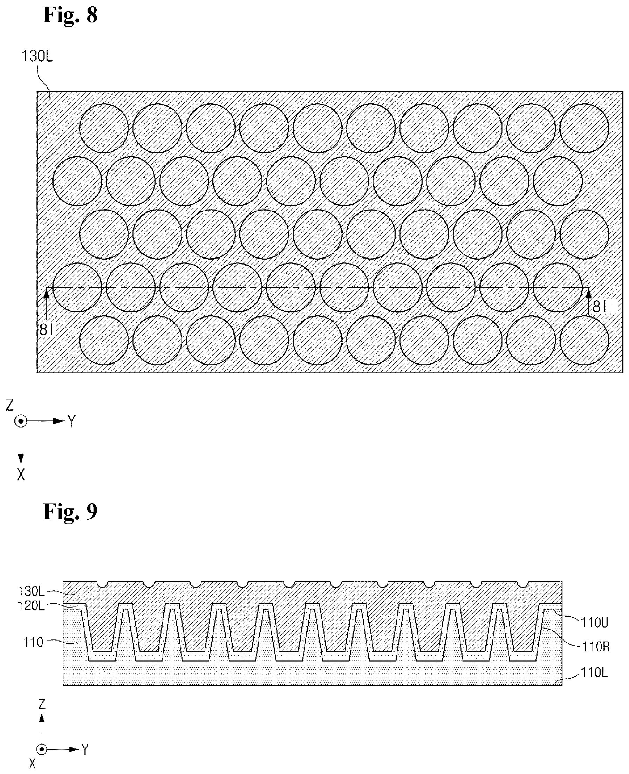

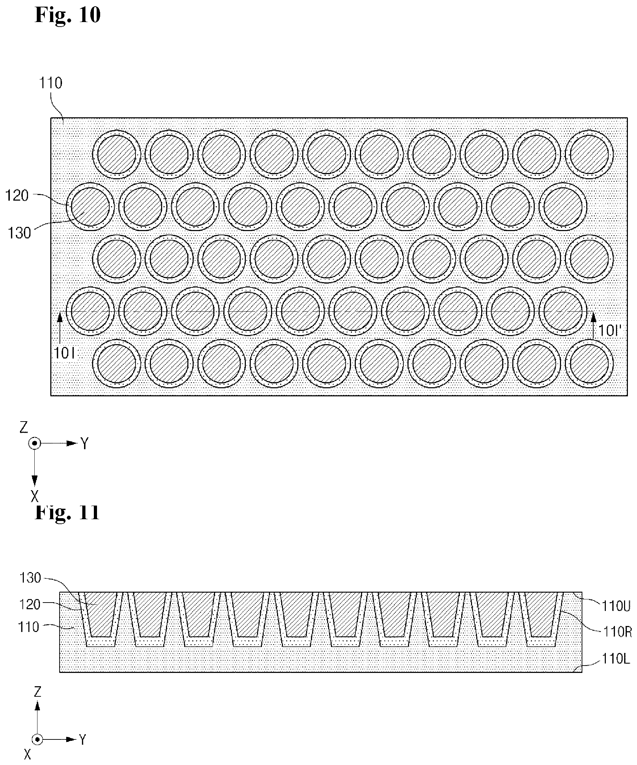

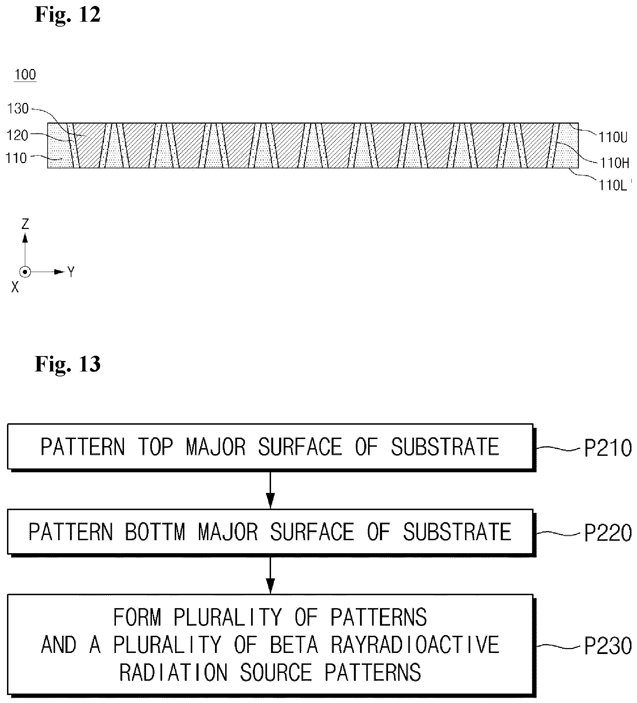

FIG. 1 is a flowchart of a method for manufacturing a unit battery layer of an integrated isotope battery according to the present invention. FIG. 2 is a plan view for describing a method for manufacturing a unit battery layer of an integrated battery according to the present invention. FIG. 3 is a cross-sectional view taken along line 2I-2I' of FIG. 2. FIG. 4 is a plan view for describing a method for manufacturing a unit battery layer of an integrated battery according to the present invention. FIG. 5 is a cross-sectional view taken along line 4I-4I' of FIG. 4. FIG. 6 is a plan view for describing a method for manufacturing a unit battery layer of an integrated battery according to the present invention. FIG. 7 is a cross-sectional view taken along line 6I-6I' of FIG. 6. FIG. 8 is a plan view for describing a method for manufacturing a unit battery layer of an integrated battery according to the present invention. FIG. 9 is a cross-sectional view taken along line 8I-8I' of FIG. 8. FIG. 10 is a plan view for describing a method for manufacturing a unit battery layer of an integrated battery according to the present invention. FIG. 11 is a cross-sectional view taken along line 10I-10I' of FIG. 10. FIG. 12 is a cross-sectional view for describing a method for manufacturing a unit battery layer of an integrated battery according to the present invention.

Referring to FIGS. 1 to 3, in step P110, a substrate 110 may be provided. The substrate 110 may comprise a first major surface and a second major surface, disposed opposite to the first major surface in a substrate thickness direction, or in the Z-axis in Fig. 2. The first major surface and the second major surface may be the top and the bottom major surfaces 110U, 110L of the substrate 110, respectively. The first major surface and the second major surface may be planar or substantially planar, when the substrate is provided in step P110.

The substrate 110 may be or include, for example, a diamond substrate, a SiC substrate, a GaN substrate, a Bi₂O₃/GeO₂ substrate, an Sm₂O₃/Bi₂O₃/GeO₂ substrate, an Sm₂O₃/Bi₂O₃/B₂O₃ substrate, an Sm₂O₃/Bi₂O₃/GeO₂/B₂O₃ substrate, or a sapphire substrate.

The substrate 110 may be processed by ion implantation or ion diffusion. The substrate 110 may be doped with a first conductivity type dopant. The first conductivity type dopant may be a p-type dopant or an n-type dopant.

The p-type dopant may include at least one of boron (B), aluminum (Al), gallium (Ga), or indium (In). The n-type dopant may include at least one of nitrogen (N), phosphorus (P), arsenic (As), or antimony (Sb).

The substrate 110 may include a material with band gap energy of 2.7 eV or more. For instance, the substrate 110 may include a material represented by AMO₃(herein, A denotes at least one material selected from the group consisting of La, Ba, Sr, and K, and M denotes at least one material selected from the group consisting of Al, In, Ga, Ti, Sn, Hf, Ta, and Zr).

For example, the substrate 110 may include at least one of BaSnO₃, BaHfO₃, BaZrO₃, BaHf₁₋ₓTiₓO₃ (here, 0<x<1), Ba₁₋ₓLaₓSnO₃ (here, 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃ (here, 0<x<1), LaGaO₃, SrTiO₃, KTaO₃, HfSiO₄, Ta₃Ti₂Oₓ (here, 0<x<1), or LaAlO₃.

Thereafter, referring to FIGS. 1, 4 and 5, in step P120, the substrate 110 may be patterned. In this step, a plurality of recesses 110R is formed, e.g., in the first or top major surface 110U of the substrate 110. The substrate 110 may be patterned, for example, by reactive ion etching (RIE) including low-temperature etching or ion beam etching. The substrate 110 may be patterned by laser beams. The substrate 110 may be also patterned by anisotropic wet etching.

Step P120 may include forming a mask pattern on the substrate 110, e.g., on the top major surface 110U of the substrate 110. The mask pattern may be formed by photolithography. The mask pattern may expose a portion of the substrate 110 to be removed, e.g., by etching. The exposed portion may correspond to a portion in which the plurality of recesses 110R are to be formed. Further, the mask pattern may cover the other portion of the substrate 110 not to be removed, e.g., a non-etched portion of the substrate 110. The covered portion may correspond to a portion between the plurality of recesses 110R. A hard mask may be additionally provided between the mask pattern and the substrate 110.

Thus, generally, the plurality of recesses 110R may be formed by selectively removing material of the substrate 110 from the first major surface 110U.

The plurality of recesses 110R may have, for example, a circular shape. That is, when viewed from above, e.g., along the Z-axis direction towards the top major surface 110U, the recesses 110R may have a circular circumference. Alternatively or additionally, the recesses 110R may have a constant radius in a plane perpendicular to the Z-axis direction. This plane may be, for example, defined by the top major surface 110U of the substrate 110. A "constant radius" is not limited to a perfectly constant radius but may also include a shape in which the respective surface defining the radius has some corrugations etc. For example, the radius may deviate from a perfectly constant average radius by not more than 10 percent, preferably by not more than 5 percent.

Referring to FIGS. 2 to 12, X-axis direction is perpendicular to Z-axis direction, and Y-axis direction is perpendicular to both Z-axis direction and X-axis direction. The X-axis direction and the Y-axis direction may be substantially parallel to the top major surface 110U of the substrate 110. Generally, X-axis direction, Y-axis direction, and Z-axis direction may be substantially perpendicular to one another.

Alternatively, the plurality of recesses 110R may also be arranged in a honeycomb structure, in particular, when the plurality of recesses 110R have the circular planar shape. When the plurality of recesses 110R are arranged in the honeycomb structure, the centers of the plurality of recesses 110R may be located at or substantially at the vertices and centers of a plurality of regular hexagons that have the same size and fill a plane. "Substantially at the vertices and centers" in this context may be understood such that the centers of the recesses 110R may also be positioned distanced in a predefined radius around the respective vertex or center. The predefined radius, for example, may be smaller than 25 percent of a diameter of the recesses. The "center" of a respective recess may correspond to a central axis of the respective recess.

Each or at least some of the plurality of recesses 110R may have a variable width along the Z-axis direction (e.g., a horizontal width such as a width in the Y-axis direction). For example, a respective recess 110R may have a tapered shape in the Z-axis direction. The recesses 110R may extend from the top major surface 110U in the Z-axis direction. The width of each or at least some of the plurality of recesses 110R may decrease as a distance from the top major surface 110U increases. Specifically, a width of a respective recess 110R at a first depth from the top major surface 110U may be smaller than a width of the recess 110R at a second depth from the top major surface 110U, insofar as the second depth is smaller than the first depth.

Next, referring to FIGS. 1, 6 and 7, in step P130, a layer 120L may be formed. In particular, the layer 120L may be formed on the top major surface 110U and within the plurality of recesses 110R, i.e., on an inner surface defining the recesses 110R. The layer 120L may have a uniform or substantially uniform thickness and thus have a conformal shape with the underlying structure. It may be understood that when the layer 120L is said to have a conformal shape, the shape of the underlying structure (i.e., the substrate 110 having the plurality of recesses 110R formed therein) is transferred to the layer 120L sitting on top.

The layer 120L may be formed by chemical vapor deposition (CVD) or physical vapor deposition (PVD) but is not limited thereto. The layer 120L may be formed by an oxidation process of a metal layer formed by metal CVD.

The layer 120L may include a metal oxide with band gap energy of 2.7 eV or more. Optionally, the layer 120L may include a material represented by AMO₃ (here, A denotes at least one material selected from the group consisting of La, Ba, Sr, and K, and M denotes at least one material selected from the group consisting of Al, In, Ga, Ti, Sn, Hf, Ta, and Zr).

For example, the layer 120L may include at least one of BaSnO₃, BaHfO₃, BaZrO₃, BaHf₁₋ₓTiₓO₃ (here, 0<x<1), Ba₁₋ₓLaₓSnO₃ (here, 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃ (here, 0<x<1), LaGaO₃, SrTiO₃, KTaO₃, HfSiO₄, Ta₃Ti₂Oₓ (here, 0<x<1), or LaAlO₃.

The layer 120L, in particular, when comprising one or more of the metal oxides listed above, is stable even in high-temperature and high-humidity environments and has high carrier mobility. A carrier movement in the layer 120L does not show inelastic collision. Accordingly, an integrated isotope battery manufactured based on the layer 120L may have high energy efficiency and excellent heat dissipation characteristics.

Optionally, carrier mobility in the layer 120L may be about 45 cm²/(Vs) or more. Preferably, carrier mobility in the layer 120L may be about 80 cm²/(Vs) or more. More preferably, carrier mobility in the layer 120L may be about 120 cm²/(Vs) or more. Further preferably, carrier mobility in the layer 120L may be about 300 cm²/(Vs) or more.

The layer 120L may include one selected from a doped semiconductor material, a compound semiconductor, an oxide semiconductor, or a metal alloy. According to exemplary embodiments, the layer 120L may include one selected from boron (B)-doped silicon (Si), silicon (Si) doped with one of phosphorus (P) and arsenic (As), zinc (Zn)-doped gallium arsenide (GaAs), gallium arsenide (GaAs) doped with one of silicon (Si) and tellurium (Te), boron (B)-doped germanium (Ge), germanium (Ge) doped with one of phosphorus (P) and antimony (Sb), magnesium (Mg)-doped gallium nitride (GaN), silicon (Si)-doped gallium nitride (GaN), silicon carbide (SiC) doped with one of aluminum (Al) and boron (B), silicon carbide (SiC) doped with one of nitrogen (N) and phosphorus (P), zinc (Zn)-doped indium phosphide (InP), indium phosphide (InP) doped with one of sulfur (S) and silicon (Si), cadmium telluride (CdTe), cadmium sulfide (CdS), tin oxide (SnO), and zinc oxide (ZnO).

The layer 120L may be doped with a second conductive type dopant opposite to that of the first conductive type dopant. For example, the second conductivity type dopant may be an n-type dopant, when the first conductivity type dopant is a p-type dopant, and may be a p-type dopant, when the first conductivity type dopant is an n-type dopant. Accordingly, a p-n junction and a depletion region due to the p-n junction may be formed between the substrate 110 and the layer 120L. Generally, the substrate 110 and the layer 120L may have opposite conductivity types.

Next, referring to FIGS. 1, 8 and 9, in step P140, a radioactive radiation source layer 130L may be formed. In particular, the radioactive radiation source layer 130L, which is a layer containing radioactive isotopes, may be formed or deposited on the layer 120L, which include the portions of the layer 120L formed within the recesses 110R as well as the portions of the layer 120L formed outside the recesses, e.g., on the top major surface 110U of the substrate. The radioactive radiation source layer 130L may be formed by evaporation, sputtering, CVD, electroplating, or electroless plating. The radioactive radiation source layer 130L may be formed sufficiently to fill up the recesses 110R. When the radioactive radiation source layer 130L is formed by electroplating or electroless plating, a seed layer may be formed between the radioactive radiation source layer 130L and the layer 120L.

The radioactive radiation source layer 130L may include a radioactive isotope. The radioactive isotope may emit beta rays and/or may emit radiation other than beta rays, such as alpha rays or gamma rays.

The radioactive radiation source layer 130L may include a radioactive isotope that emits beta rays. For example, the radioactive radiation source layer 130L may include one or more selected from a group consisting of tritium (³H), calcium-45 (⁴⁵Ca), nickel-63 (⁶³Ni), copper-67 (⁶⁷Cu), strontium-90 (⁹⁰Sr), promethium-147 (¹⁴⁷Pm), osmium-194 (¹⁹⁴Os), thulium-171 (¹⁷¹Tm), thallium-204 (²⁰⁴Tl), tantalum-182 (¹⁸²Ta), tantalum-179 (¹⁷⁹Ta), cadmium-115 (¹¹⁵Cd), cadmium-113 (¹¹³Cd), cadmium-109 (¹⁰⁹Cd), germanium-68 (⁶⁸Ge), germanium-75 (⁷⁵Ge), cerium-159 (¹⁵⁹Ce), cerium-141 (¹⁴¹Ce), cerium-144 (¹⁴⁴Ce), tungsten-181 (¹⁸¹W), and tungsten-185 (¹⁸⁵W). However, the present invention is not limited to these.

Next, referring to FIGS. 1, 10 and 11, in step P150, a first chemical mechanical polishing (CMP) process may be performed. The top major surface 110U of the substrate 110 may be an end point of the first CMP process. A CMP process may be determined by a change in reflectance inside a CMP chamber or a change in the concentration of a specific chemical component.

By the first CMP process, the layer 120L may be divided into a plurality of patterns 120 that are physically separated from each other, i.e., not in direct contact with each other. By the first CMP process, the radioactive radiation source layer 130L may be divided into a plurality of radioactive radiation source patterns 130 that are physically separated from each other, i.e., not in direct contact with each other. A top major surface of each of the plurality of patterns 120 and atop major surface of each of the plurality of radioactive radiation source patterns 130 may be coplanar with the top major surface 110U of the substrate 110.

Thus, in step P150, a first removal operation is carried out which includes removing the radioactive radiation source layer 130L, and the layer 120L from the top major surface 110U of the substrate 110. Thereby, in each recess 110R, a pattern 120 and a radioactive radiation source pattern 130 are formed. Although CMP is a possible process to remove layers 130L, 120L from the top major surface 110U of the substrate 110, the invention is not limited to a CMP process. Rather, it may also be possible to remove the layers 130L, 120L from the top major surface 110U of the substrate 110 by, for example, laser ablation, an etch-back process (e.g., Reactive Ion Etching or Plasma Etching), or mechanical grinding processes such as lapping.

As a result of step P150, a pattern is formed within each recess 110R, and said pattern includes the non-removed part of the layer 120L forming a respective pattern 120, and the non-removed part of the radioactive radiation source layer 130L forming a radioactive radiation source pattern 130.

Thereafter, referring to FIGS. 1, 11, and 12, in step P160, a second CMP process may be performed. The second CMP process may be performed on the second or bottom major surface 110L of the substrate 110. The plurality of radioactive radiation source patterns 130 may be an end point of the second CMP process. That is, material of the substrate 110 may be removed starting from the bottom major surface 110L until the radioactive radiation source patterns 130 are exposed. By the second CMP process, an integrated isotope battery 100 including the substrate 110, the plurality of patterns 120, and the plurality of radioactive radiation source patterns 130 may be provided.

Just like step P150, step P160 is generally a second removal operation including partial removal of the substrate 110 starting from the bottom major surface 110L until the radioactive radiation source patterns 130 are exposed. For this purpose, instead of a CMP process other removal processes may be used, e.g., laser ablation, an etch-back process (e.g., Reactive Ion Etching or Plasma Etching), or mechanical grinding processes such as lapping.

By removing the material in step P160, the plurality of recesses 110R of FIG. 11 may become a plurality of holes 110H extending to a new lower surface 110L' of the substrate 110. Each of the plurality of holes 110H may extend entirely through the substrate 110, e.g., from the top major surface 110U till the new bottom major surface 110L' of the substrate 110 in the Z-axis direction. That is, in the integrated isotope battery 100, the recesses 110R of the substrate 110 may be realized as through holes. A lower surface of each of the plurality of patterns 120 and a lower surface of each of the plurality of radioactive radiation source patterns 130 may be coplanar with the bottom major surface 110L' of the substrate 110.

Optionally, the substrate 110 may include, for example, a plurality of recesses 110R in the form of holes 110H having a tapered shape. The plurality of holes 110H may extend in the Z-axis direction perpendicular to the two major surfaces 110U, 110 L' of the substrate 110. The plurality of holes 110H may penetrate the substrate 110, i.e., extend through the entire thickness of the substrate 110 between the top major surface 110U and the bottom major surface 110 L' thereof.

Each of the plurality of radioactive radiation source patterns 130 may be formed in a respective one of the plurality of recesses 110R, e.g., holes 110H. Each of the plurality of radioactive radiation source patterns 130 may have a tapered shape. That is, the recesses gradually become narrower or thinner towards the bottom major surface110 L' of the substrate 110.

The plurality of patterns 120 may be in contact with the substrate 110, in particular, with an inner circumferential surface of the substrate 110 defining the recess 110R. The plurality of patterns 120 may have a conductive type opposite to that of the substrate 110. Each of the plurality of patterns 120 may be positioned between the substrate 110 and a respective one of the plurality of radioactive radiation source patterns 130. Each of the plurality of patterns 120 may have a uniform or substantially uniform thickness. FIG. 13 is a flowchart of a method for manufacturing a unit battery layer of an integrated isotope battery according to the present invention.

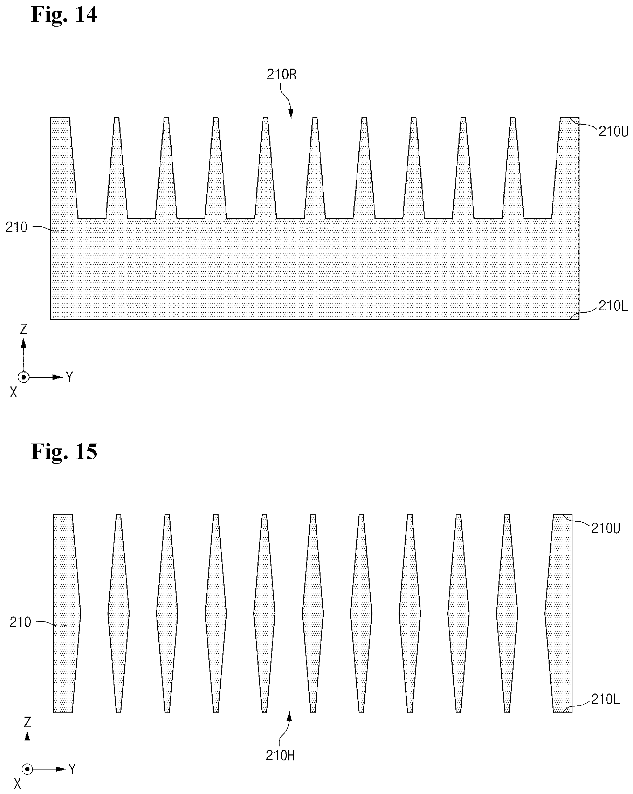

FIGS. 14 to 16 are diagrams for describing respective steps of a method for manufacturing method a unit battery layer of an integrated isotope battery according to the present invention.

The method to be explained hereinafter, making reference to FIGS. 8 to 11, relates to a further preferred embodiment which may be optionally carried out in addition to the steps so far described in the present disclosure. In other words, it is not a separate embodiment which excludes the other embodiments. Insofar, the preceding description part also applies to the subsequent part; and unnecessary repetition will be avoided.

Referring to FIGS. 13 and 14, in step P210, a top major surface 210U of a substrate 210 may be patterned. The substrate 210 may include the same material as the substrate 110 of FIG. 2. The substrate 210 may be doped in the same manner as the substrate 110 of FIG. 2. The substrate 210 may be patterned, for example, by reactive ion etching (RIE) including low-temperature etching or ion beam etching. The substrate 110 may be also patterned by anisotropic wet etching. A plurality of recesses 210R may be formed by patterning the substrate 210, i.e., selectively removing material of the substrate 210 from the top major surface 210U. Optionally, the plurality of recesses 210R may be formed starting from the top major surface 210U of the substrate 210 till around the middle of the thickness of the substrate 210.

In other words, the patterning may be performed until the bottom of the plurality of recesses 210R reaches approximately the midpoint of the distance between the first or top major surface and the second or bottom major surface of the substrate 210. However, this patterning depth is a mere example, and any other depth can be chosen depending on various necessities and/or requirements in the manufacturing.

Each of the plurality of recesses 210R may have, for example, a circular shape or a linear shape, and so forth. Furthermore, each of the plurality of recesses 210R may be arranged as a matrix, arranged in a honeycomb structure, or form a line-and-space pattern, in accordance with the previous description part.

Each or at least some of the plurality of recesses 210R may have a variable width along the Z-axis direction. For example, a respective recess 210R may have a tapered shape in the Z-axis direction. The recesses 210R may extend from the top major surface 210U in the Z-axis direction. The width of each or at least some of the plurality of recesses 210R may decrease as a distance from the top major surface 210U increases. Specifically, a width of a respective recess 210R at a first depth from the top major surface 210U may be smaller than a width of the recess 210R at a second depth from the top major surface 210U, insofar as the second depth is smaller than the first depth.

Next, referring to FIGS. 13 to 15, in step P220, a bottom major surface 210L of the substrate 210 may be patterned. The bottom major surface 210L may be patterned by the same methods as the top major surface 210U, e.g., by RIE or ion beam etching.

Points for patterning on the bottom major surface 210L may be aligned with points for patterning on the top major surface 210U, such that imaginary lines connecting respective points on the bottom and top major surfaces 210L, 210U are parallel with one another and, at the same time, perpendicular to the two major surfaces 210L, 210U.

The patterning starts from the bottom major surface 210L of the substrate 210 and may finish at around the middle of the thickness of the substrate 210, where the plurality of recesses 210R starting from the top major surface 210U ends. In other words, the patterning may be performed until the plurality of recesses starting from the bottom major surface 210L is connected with the plurality of recesses 210R extending from the top major surface 210U. Once the patterning of the bottom major surface 210L is finished, the plurality of recesses 210R extending from the top major surface 210U of the substrate 210 and a plurality of recesses formed from the bottom major surface 210L are respectively connected with each other, to thereby form a plurality of holes 210H extending through the entire thickness of the substrate 210.

Each of the plurality of holes 210H so formed may have an hourglass shape. In other words, each of the plurality of holes 210H may have a narrow middle.

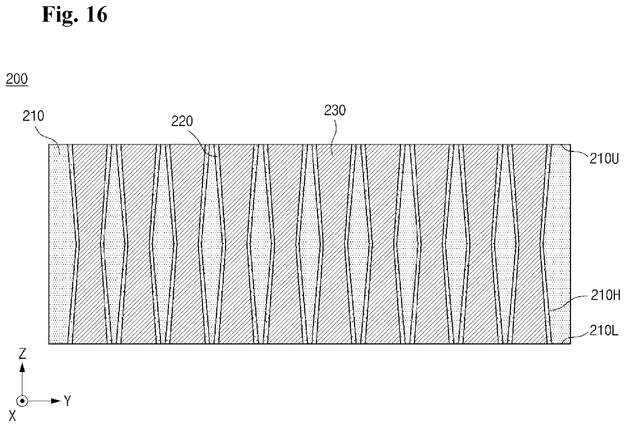

Next, referring to FIGS. 13 and 16, in step P230, a plurality of patterns 220 and a plurality of radioactive radiation source patterns 230 may be formed. Herein, the patterns 220 may be formed in the same way as the patterns 120; see steps P130, P150 and P160, making reference to FIG. 1. Furthermore, the radioactive radiation source patterns 230 may be formed in the same way as the radioactive radiation source patterns 130; see steps P140, P150 and P160, making reference to FIGS. 1. Accordingly, an integrated isotope battery 200 including the substrate 1100, the plurality of patterns 220, and the plurality of beta ray source patterns 230 may be provided.

In step P230, the forming of the plurality of patterns 220 and the plurality of radioactive radiation source patterns 230 may include: forming a layer, e.g., by CVD, PVD, or an oxide process (refer to step P130); forming a radioactive radiation source layer, e.g., by evaporation, sputtering, CVD, electroplating, or electroless plating (refer to step P140); performing a first CMP process by setting the top major surface 210U of the substrate 210 as an end point, (refer to step P150); and performing a second CMP process by setting the bottom major surface 210L of the substrate 210 as an end point (refer to step P160).

The plurality of patterns 220 may include the same material as the layer 120L of FIG. 7. The radioactive radiation source patterns 230 may include the same material as the radioactive radiation source layer 130L of FIG. 9.

The plurality of patterns 220 may have a uniform or substantially uniform thickness. Accordingly, the shapes of the plurality of holes 210H may be transcribed to the plurality of patterns 220. That is, each of the plurality of patterns 220 may have a conformal shape with the underlying respective holes 210H.

The plurality of radioactive radiation source patterns 230 may be positioned on the patterns 220, within respective ones of the plurality of holes 210H. The plurality of radioactive radiation source patterns 230 may fill up a space defined by the patterns 220. The plurality of patterns 220 may be interposed between respective ones of the radioactive radiation source patterns 230 and the substrate 210. Each of the plurality of radioactive radiation source patterns 230 may have an hourglass shape. In other words, each of the plurality of radioactive radiation source patterns 230 may have a narrow middle.

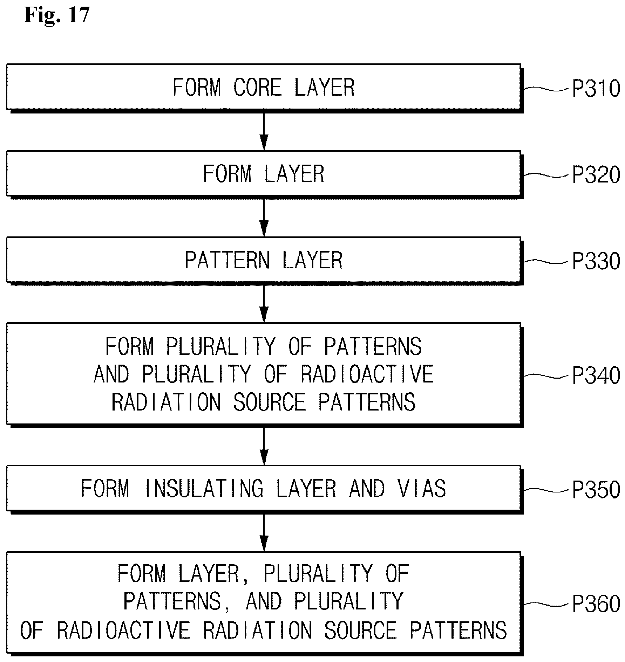

FIG. 17 is a flowchart of a method for manufacturing an integrated isotope battery.

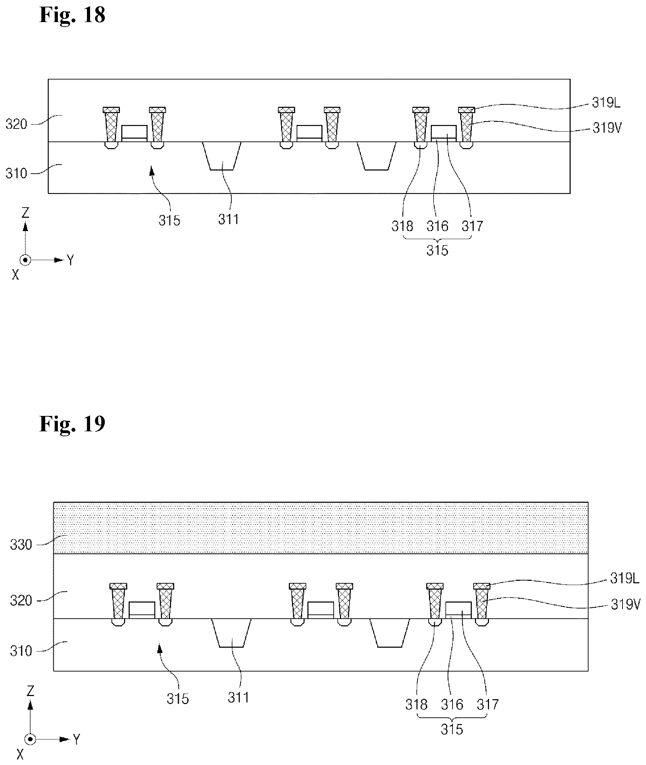

FIGS. 18 to 21 are diagrams for describing a method for manufacturing an integrated isotope battery according to the present invention.

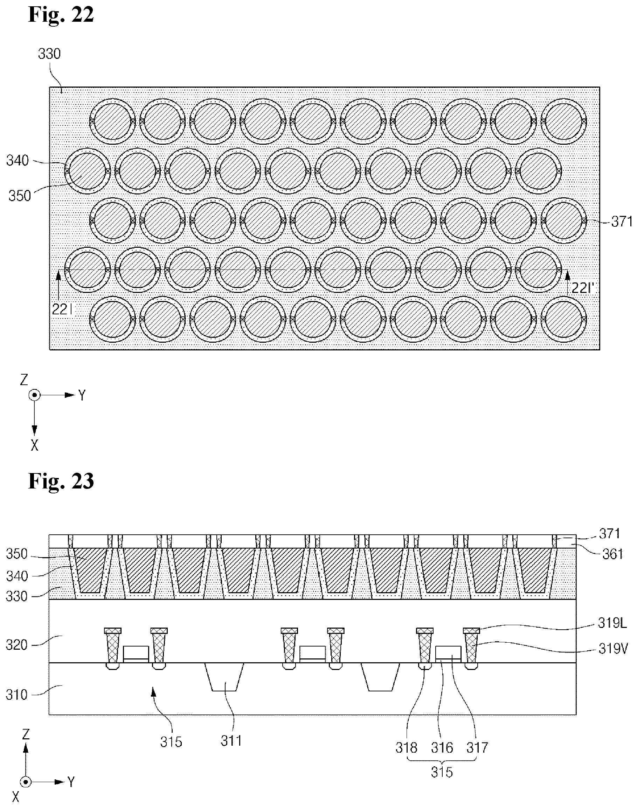

FIG. 22 is a plan view for describing a method for manufacturing an integrated isotope battery.

FIG. 23 is a cross-sectional view taken along line 22I-22I' of FIG. 22.

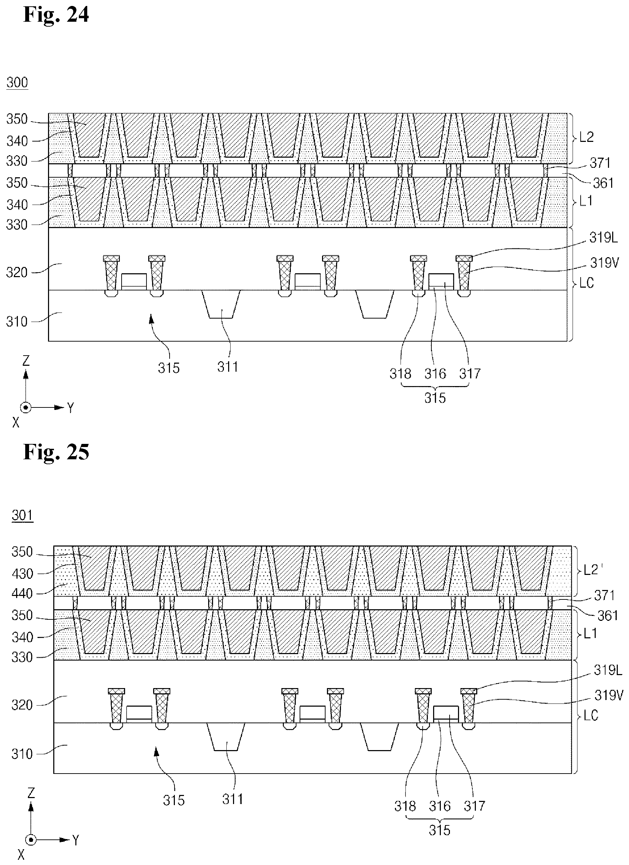

FIG. 24 is a cross-sectional view for describing a method for manufacturing an integrated isotope battery.

Referring to FIGS. 17 and 18, in step P310, a core layer LC may be formed. The forming of the core layer LC may include at least one or any combination of the following steps: forming an isolation film 311 on a substrate 310; forming a p-well region and an n-well region sequentially (or in a reverse order) on the lower substrate 310 by, e.g., an ion implantation process using a photoresist pattern; forming peripheral transistors 315; patterning a conductive material; and providing an insulating layer 320 to form a conductive vias 319V and conductive lines 319L.

For example, the substrate 310 may include a semiconductor material such as silicon, germanium or silicon-germanium, and may further include an epitaxial layer, a silicon-on-insulator (SOI) layer, a germanium-on-insulator (GOI) layer, a semiconductor-on-insulator (SeOI) layer, or the like.

Each of the peripheral transistors 315 may include a gate oxide layer 316, a gate electrode 317, and source/drain regions 318. Each of the peripheral transistors 315 may be formed through a component metal-oxide-semiconductor (CMOS) logic process.

Here, the CMOS logic process may include at least one or any combination of the following steps: forming the gate oxide film 316; forming the gate electrode 317 that includes polysilicon or metal; and forming the source/drain regions 318 through ion implantation. Although not clearly shown, gate spacers may be further formed after the formation of the gate electrode 317.

Each of the conductive vias 319V and the conductive lines 319L may include a conductive material. Each of the conductive vias 319V and the conductive lines 319L may include copper but is not limited thereto. Each of the conductive vias 319V and the conductive lines 319L may include one or more of tungsten, tantalum, cobalt, nickel, tungsten silicide, tantalum silicide, cobalt silicide, and nickel silicide. Each of the conductive vias 319V and the conductive lines 319L may include polysilicon.

Each of the conductive vias 319V may extend in the Z-axis direction. The conductive vias 319V may be embedded in an insulating layer 320. The conductive vias 319V may be connected to the peripheral transistors 315 and/or the conductive lines 319L.

Each of the conductive lines 319L may extend in a horizontal direction. The conductive lines 319L may be embedded in the insulating layer 320. Each of the conductive lines 319L may extend, for example, in the X-axis direction and/or the Y-axis direction. The conductive lines 319L may be connected to the conductive vias 319V.

The insulating layer 320 may include at least one of silicate (e.g., TEOS), silicon nitride (SiN), hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, or aluminum oxide.

The insulating layer 320 may include a plurality of insulating layers that are formed sequentially on top of another. For example, in each layer, an insulating layer may be formed to form conductive vias 319V, and in each layer, an insulating layer may be formed to form conductive lines 319L.

Next, referring to FIGS. 17 and 19, in step P320, a layer 330 (e.g., a semiconductor layer) may be formed on top of the core layer LC provided in step P310. The layer 330 may be formed, for example, by CVD or epitaxial growth. The layer 330 may be doped with a first dopant. The first dopant may be introduced into the layer 330 during the growth of the layer 330, or the layer 330 may be doped with the first dopant by ion implantation and diffusion after the layer 330 is formed.

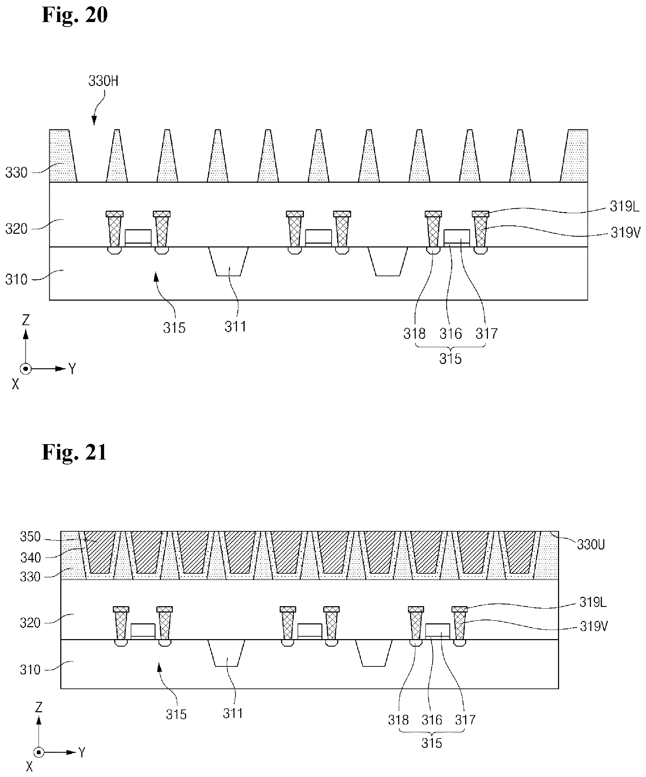

Next, referring to FIGS. 17 and 20, in step P330, the layer 330 may be patterned. The layer 330 may be patterned, for example, by RIE or ion beam etching. The layer 330 may be also patterned by other processes, such as anisotropic wet etching.

In step P 330, the layer 330 may be patterned so as to form a plurality of recesses, or holes 330H, exposing the insulating layer 320 at bottoms thereof. Each of the plurality of holes 330H may have, for example, a circular shape or a linear shape, and so forth. Furthermore, each of the plurality of holes 330H may be arranged as a matrix, arranged in a honeycomb structure, or form a line-and-space pattern, in accordance with the previous parts of this disclosure.

Each or at least some of the plurality of holes 330H may have a variable width along the Z-axis direction. For example, a respective hole 330H may have a tapered shape in the Z-axis direction. The holes 330H may extend from the top major surface 210U in the Z-axis direction. The width of each or at least some of the plurality of holes 330H may decrease as it gets closer to the underlying substrate 310. Specifically, a width of a respective hole 330H at a first level from the underlying substrate 310 may be smaller than a width of the hole 330H at a second level from the underlying substrate 310, insofar as the second level is greater than the first level.

Next, referring to FIGS. 17 and 21, in step P340, a plurality of patterns 340 and a plurality of radioactive radiation source patterns 350 may be formed. Herein, the patterns 340 may be formed in the same way as the patterns 120, 220; see steps P130, P150 and P160, making reference to FIG. 1, as well as step P230, making reference to FIG. 13. Furthermore, the radioactive radiation source patterns 350 may be formed in the same way as the radioactive radiation source patterns 130, 230; see steps P140, P150 and P160, making reference to FIG. 1, as well as step P230, making reference to FIGS. 13.

The forming of the plurality of patterns 340 and the plurality of radioactive radiation source patterns 350 may include at least one or any combination of the following steps: forming a layer, e.g., by CVD, PVD, or an oxidation process (refer to step P130); forming a radioactive radiation source layer, e.g., by evaporation, sputtering, CVD, electroplating, or electroless plating (refer to step P140); and performing a CMP process on a top major surface of the layer 330 as an end point (refer to step P150).

The plurality of patterns 340 may at least partially fill the plurality of holes 330H. The plurality of patterns 340 may have a uniform or substantially uniform thickness. Each of the plurality of patterns 340 may have a conformal shape with the underlying respective holes 330H. For example, the patterns 340 may have a cup shape.

The patterns 340 may be doped with a second dopant, with a conductive type opposite to that of the first dopant. Accordingly, the conductive type of the patterns 340 being opposite to that of the layer 330, a p-n junction and a depletion region may be formed at an interface between each of the patterns 340 and the layer 330. The layer 330 and the patterns 340 may include one selected from a doped semiconductor material, a compound semiconductor, an oxide semiconductor, or a metal alloy.

Preferably, the layer 330 may include silicon (Si) doped with boron (B), and the plurality of patterns 340 may include silicon (Si) doped with phosphorus (P) or arsenic (As). Otherwise, the layer 330 may include silicon Si doped with phosphorus (P) or arsenic (As), and the plurality of patterns 340 may include silicon (Si) doped with boron (B).

Alternatively or additionally, the layer 330 may include gallium arsenic (GaAs) doped with zinc (Zn), and the plurality of patterns 340 may include gallium arsenic (GaAs) doped with silicon (Si) or tellurium (Te). Otherwise, the layer 330 may include gallium arsenic (GaAs) doped with silicon (Si) or tellurium (Te), and the plurality of patterns 340 may include gallium arsenic (GaAs) doped with zinc (Zn).

Alternatively or additionally, the layer 330 may include germanium (Ge) doped with boron (B), and the plurality of patterns 340 may include germanium (Ge) doped with phosphorus (P) or antimony (Sb). Otherwise, the layer 330 may include germanium (Ge) doped with phosphorus (P) or antimony (Sb), and the plurality of patterns 340 may include germanium (Ge) doped with boron (B).

Alternatively or additionally, the layer 330 may include gallium nitride (GaN) doped with magnesium (Mg), and the plurality of patterns 340 may include gallium nitride (GaN) doped with silicon (Si). Otherwise, the layer 330 may include gallium nitride (GaN) doped with silicon (Si), and the plurality of patterns 340 may include gallium nitride (GaN) doped with magnesium (Mg).

Alternatively or additionally, the layer 330 may include silicon carbide (SiC) doped with aluminum (Al) or boron (B), and the plurality of patterns 340 may include silicon carbide (SiC) doped with nitrogen (N) or phosphorus (P). Otherwise, the layer 330 may include silicon carbide (SiC) doped with nitrogen (N) or phosphorus (P), and the plurality of patterns 340 may include silicon carbide (SiC) doped with aluminum (Al) or boron (B).

Alternatively or additionally, the layer 330 may include indium phosphide (InP) doped with zinc (Zn), and the plurality of patterns 340 may include indium phosphide (InP) doped with sulfur (S) or silicon (Si). Otherwise, the layer 330 may include indium phosphide (InP) doped with sulfur (S) or silicon (Si), and the plurality of patterns 340 may include indium phosphide (InP) doped with zinc (Zn).

Alternatively or additionally, the layer 330 may include cadmium telluride (CdTe), and the plurality of patterns 340 may include cadmium sulfide (CdS). Otherwise, the layer 330 may include cadmium sulfide (CdS), and the plurality of patterns 340 may include cadmium telluride (CdTe).

Alternatively or additionally, the layer 330 may include tin oxide (SnO), and the plurality of patterns 340 may include zinc oxide (ZnO). Otherwise, the layer 330 may include zinc oxide (ZnO), and the plurality of patterns 340 may include tin oxide (SnO).

The radioactive radiation source patterns 350 may include the same material as the radioactive radiation source layer 130L of FIG. 9. Respective ones of the plurality of radioactive radiation source patterns 350 may have a tapered shape. The patterns 340 may be interposed between the layer 330 and the respective radioactive radiation source patterns 350.

Next, referring to FIGS. 17, 22 and 23, in step P350, an insulating layer 361 and a plurality of vias 371 may be formed on top of the structure obtained in step P340, including the layer 330, the patterns 340 and the radioactive radiation source patterns 350. The insulating layer 361 may include one of the materials described as examples with respect to the insulating layer 320. The plurality of vias 371 may extend through the entire thickness of the insulating layer 361 in the thickness direction thereof, i.e., in Z-axis direction in FIG 17. The plurality of vias 371 may be in contact with a respective one of the plurality of patterns 340. Furthermore, the vias 371 may be exposed outward through the top major surface of the insulating layer 361. The vias 371 may include an electrically conductive material. For example, the vias 371 may include a metal. Optionally, the vias 371 may include at least one of aluminum (Al), copper (Cu), tungsten (W), or titanium (Ti). Based on the above description, those of ordinary skill in the art will be able to easily derive an embodiment with a wiring structure embedded in the insulating layer 361, the wiring structure including two or more layers of vias and one or more layers of conductive patterns.

The forming of the plurality of vias 371 may include at least one or any combination of the following steps: depositing an insulating material to form an insulating material layer; etching the insulating material layer to form a plurality of via holes exposing upper surfaces of the plurality of patterns 340; providing a conductive material layer filling the plurality of via holes; and separating the conductive material layer to form the plurality of vias 371 through a planarization process.

Next, referring to FIGS. 17 and 24, in step P360, the layer 330, the plurality of patterns 340, and the plurality of radioactive radiation source patterns 350 may be formed on top of the structure obtained in step P350, including the insulating layer 361 and the plurality of vias 371.

Step P360 may include the same processes performed in steps P320, P330, and P340. That is, the layer 330, the plurality of patterns 340, and the plurality of radioactive radiation source patterns 350 of the second battery layer L2 may be provided by substantially the same method as the layer 330, the plurality of patterns 340, and the plurality of radioactive radiation source patterns 350 of the first battery layer L1. Thus, the layer 330, the plurality of patterns 340, and the plurality of radioactive radiation source patterns 350 of the second battery layer L2 may be substantially the same as the layer 330, the plurality of patterns 340, and the plurality of radioactive radiation source patterns 350 of the first battery layer L1.

Accordingly, after carrying out the step P360, an integrated isotope battery 300 including a core layer LC, a first battery layer L1, and a second battery layer L2 may be provided. The first battery layer L1 may be arranged on the core layer LC. The insulating layer 361 may be interposed between the first battery layer L1 and the second battery layer L2.

The core layer LC may include a plurality of transistors 315 on the substrate 310. An additional passive element may be formed on the substrate 310. Preferably, the core layer LC may include a voltage regulator configured to adjust resultant voltage from the first and the second battery layers L1 and L2. For example, the core layer LC may include a linear voltage regulator, a buck regulator, a booster regulator, or a buck-boost regulator.

Each of the first battery layer L1 and the second battery layer L2 may include the layer 330, the plurality of patterns 340, and the plurality of radioactive radiation source patterns 350. The plurality of patterns 340 of the first battery layer L1 may be electrically connected to the layer 330 of the second battery layer L2 through the plurality of vias 371. Accordingly, the first battery layer L1 may be connected to the second battery layer L2 in series.

Each of the first battery layer L1 and the second battery layer L2 of the integrated isotope battery 300 may be considered as a unit battery layer. Preferably, multiple unit battery layers may be connected in series by repetitively performing steps P350 and P360. In this way, an integrated isotope battery including multiple unit battery layers connected in series can be obtained, by way of performing a semiconductor manufacturing process on one substrate. This can effectively increase a voltage to be output from the integrated isotope battery 300.

FIG. 25 is a diagram illustrating an integrated isotope battery 301 according to the present invention.

Referring to FIG. 25, an integrated isotope battery 301 may include a core layer LC, a first battery layer L1, and a second battery layer L2'. The core layer LC and the first battery layer L1 are substantially the same as those described with reference to FIGS. 17 to 24, and thus a repetitive description thereof is omitted here.

The second battery layer L2' may include a plurality of patterns 430, a layer 440, and a plurality of radioactive radiation source patterns 350. The layer 440 may have substantially the same configuration as the layer 330. However, the layer 440 may have a conductive type opposite to that of the layer 330. Besides, the plurality of patterns 430 may have substantially the same configuration as the plurality of patterns 340. However, the patterns 430 may have a conductive type opposite to that of the plurality of patterns 340. The conductive types of the plurality of patterns 430 and the layer 440 may be opposite.

As illustrated in FIG. 25, the plurality of patterns 340 of the first battery layer L1 may be electrically connected to the layer 440 of the second battery layer L2' through the plurality of vias 371. Accordingly, the first battery layer L1 may be connected to the second battery layer L2 in parallel.

Each of the first battery layer L1 and the second battery layer L2' of the integrated isotope battery 301 may be considered as a unit battery layer. Preferably, multiple unit battery layers may be connected in parallel by repetitively performing steps P350 and P360, changing the conductive types of the layer and the patterns in each unit battery layer. In this way, an integrated isotope battery including multiple unit battery layers connected in parallel can be obtained, by way of performing a semiconductor manufacturing process on one substrate. This can effectively increase a capacity of the integrated isotope battery 301.

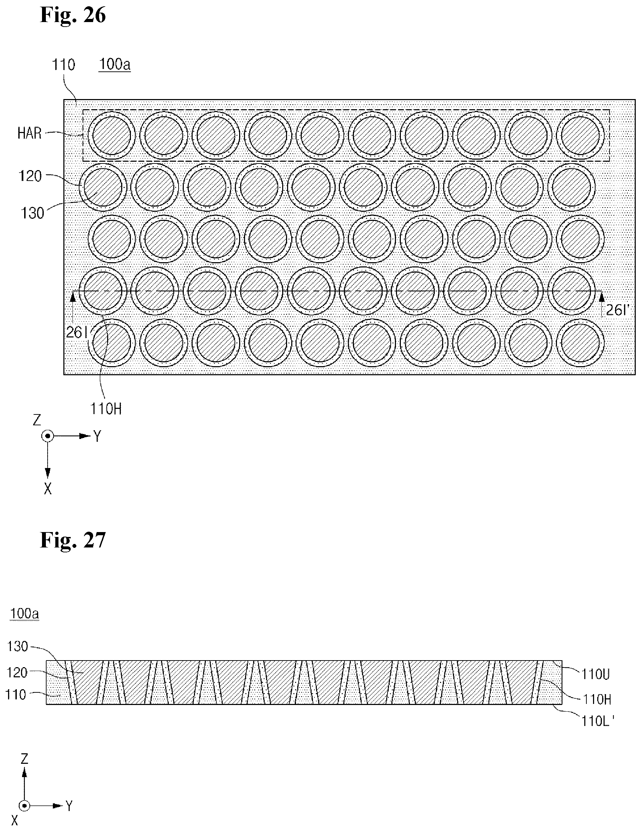

FIG. 26 is a plan view of a unit battery layer 100a of an integrated isotope battery according to the present invention.

FIG. 27 is a cross-sectional view taken along line 26I-26I' of FIG. 26.

Referring to FIGS. 26 and 27, the unit battery layer 100a may include a substrate 110, a plurality of patterns 120, and a plurality of energy source patterns 130. The substrate 110, the plurality of patterns 120, and the plurality of energy source patterns 130 are substantially the same as those described above with reference to FIGS. 1 to 12 except for an arrangement of a plurality of holes 110H, and thus, redundant description thereof is omitted here.

The plurality of holes 110H of FIGS. 26 and 27 may be arranged in a non-honeycomb structure, unlike the plurality of holes 110H of FIG. 12 arranged in the honeycomb structure. At least some of the centers of the plurality of holes 110H may be offset from the positions forming the honeycomb structure. When each of arrays of the plurality of holes 110H forming a single row in the Y-axis direction is defined as a hole array HAR, neighboring hole arrays HARs may be staggered, such that holes 110H belonging to neighboring hole arrays HARSs are not aligned in the X-axis direction. In other words, the plurality of holes 110H may be arranged in a zigzag fashion along the X-axis direction.

The plurality of patterns 120 and the plurality of energy source patterns 130 fill the plurality of holes 110H together; and thus, the above description regarding the arrangement of the plurality of holes 110H may also apply to the plurality of patterns 120 and the plurality of energy source patterns 130.

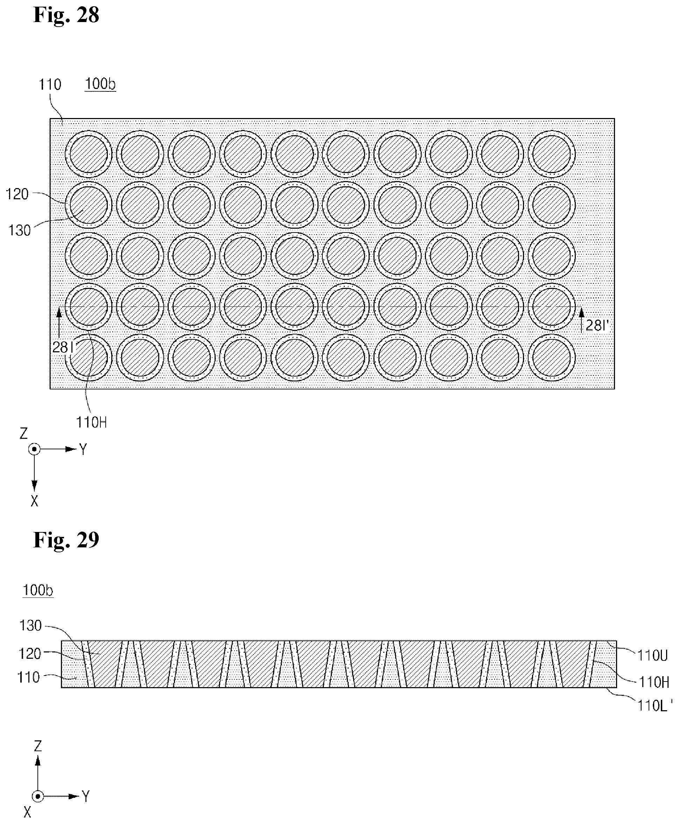

FIG. 28 is a plan view of unit battery layer 100b of an integrated isotope battery according to the present invention.

FIG. 29 is a cross-sectional view taken along line 28I-28I' of FIG. 28.

Referring to FIGS. 28 and 29, the unit battery layer 100b may include a substrate 110, a plurality of patterns 120, and a plurality of energy source patterns 130. The substrate 110, the plurality of patterns 120, and the plurality of energy source patterns 130 are substantially the same as those described above with reference to FIGS. 1 to 12 except for an arrangement of a plurality of holes 110H, and thus, redundant description thereof is omitted here.

The plurality of holes 110H may be arranged in a matrix, unlike the plurality of holes 110H of FIG. 12 arranged in the honeycomb structure. The plurality of holes 110H may be aligned in the X-axis direction. The plurality of holes 110H may be aligned in the Y-axis direction. For example, the plurality of recesses 110R may be arranged to form a respective row along the X-direction, and respective rows may be arranged spaced apart from each other along the Y-direction.

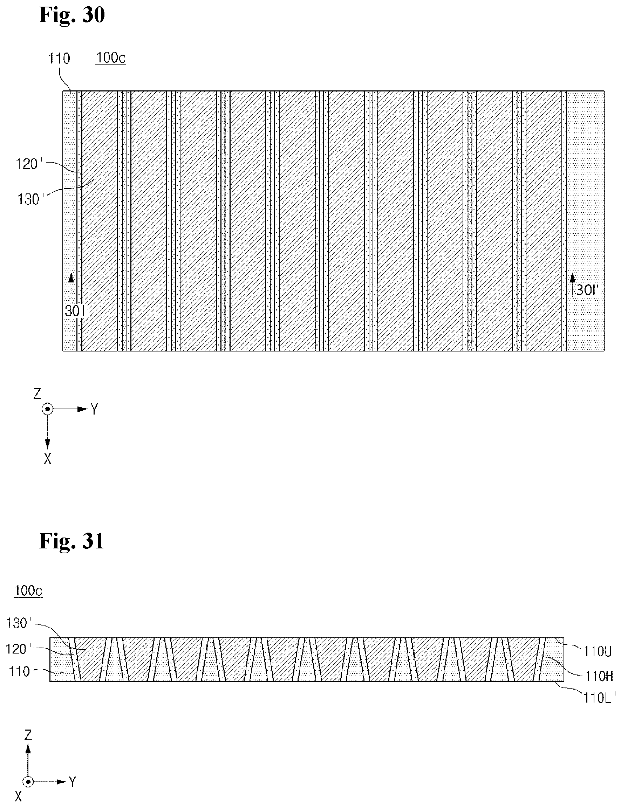

The plurality of patterns 120 and the plurality of energy source patterns 130 fill the plurality of holes 110H together; and thus, the above description regarding the arrangement of the plurality of holes 110H may also apply to the plurality of patterns 120 and the plurality of energy source patterns 130.FIG. 30 is a plan view of a unit battery layer 100c of an integrated isotope battery according to the present invention.

FIG. 31 is a cross-sectional view taken along line 30I-30I' of FIG. 30.

Referring to FIGS. 30 and 31, the unit battery layer 100c may include a substrate 110, a plurality of patterns 120', and a plurality of energy source patterns 130'. The substrate 110, the plurality of patterns 120', and the plurality of energy source patterns 130' are substantially the same as those described above with reference to FIGS. 1 to 12 except for a shape of a plurality of holes 110H', and thus, redundant description thereof is omitted here.

The plurality of holes 110H' may have a line shape, unlike the circular shape of the plurality of holes 110H of FIG. 12. The plurality of holes 110H' may form a line-and-space construction. Each of the plurality of holes 110H' may extend in the X-axis direction. The plurality of holes 110H' may be spaced apart from each other in the Y-axis direction.

Each of the plurality of holes 110H' may have a linear shape, i.e., a longitudinal shape. That is, when viewed from above, e.g., when viewed along the Z-axis direction towards the top major surface 110U, each of the plurality of holes 110H' may extend longitudinally in the X-axis direction. Generally, a "linear shape" or "longitudinal shape" may be understood to define each of the plurality of holes 110H' as having a length in first direction, e.g., in the X-axis direction, which is greater than a width in a second direction perpendicular to the first direction, e.g. in the Y-axis direction. Optionally, the length of the each of the plurality of holes 110H' in the X-axis direction may be at least 2 times greater than the width of the each of the plurality of holes 110H' in the Y-axis direction. For example, each of the plurality of holes 110H' may have a rectangular or substantially rectangular circumference, when viewed from above, along the Z-axis direction. Further, it may be possible that each of the plurality of holes 110H' has the shape of a slotted hole, that is, it may have the shape of a rectangle with rounded ends.

Each of the plurality of patterns 120' may be disposed on a sidewall of a respective one of the plurality of holes 110H'. Each of the plurality of patterns 120' may have a longitudinal shape extending in the X-axis direction. Each of the plurality of patterns 120' may have a uniform thickness.

The plurality of energy source patterns 130' may fill the plurality of holes 110H'. Each of the plurality of energy source patterns 130' may have a longitudinal shape extending in the X-axis direction. Each of the plurality of energy source patterns 130' may have a tapered shape with a decreasing width in the Z-axis direction.

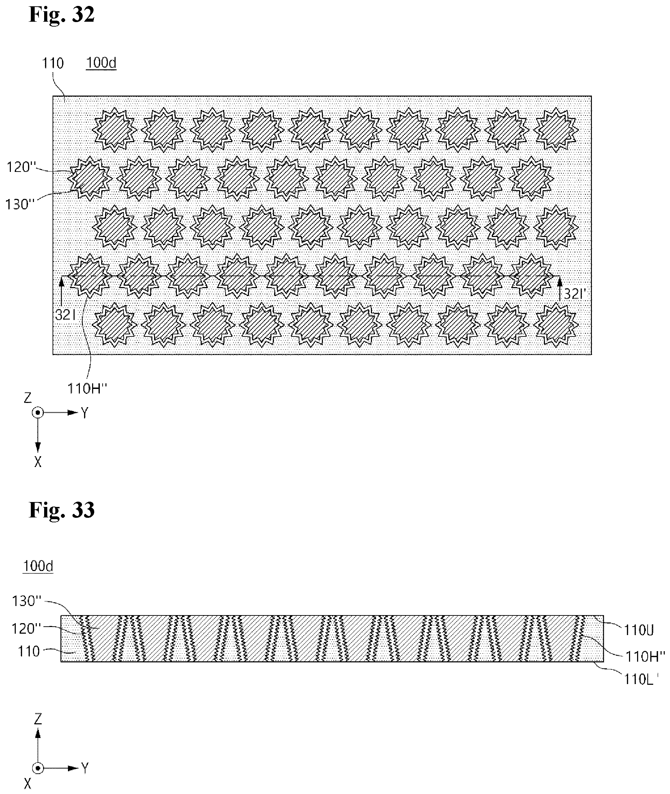

FIG. 32 is a plan view of a unit battery layer 100d of an integrated isotope battery according to the present invention.

FIG. 33 is a cross-sectional view taken along line 32I-32I' of FIG. 32.

Referring to FIGS. 32 and 33, the unit battery layer 100d may include a substrate 110, a plurality of patterns 120", and a plurality of energy source patterns 130". The substrate 110, the plurality of patterns 120", and the plurality of energy source patterns 130" are substantially the same as those described above with reference to FIGS. 1 to 12 except for a shape of a plurality of holes 110H", and thus, redundant description thereof is omitted here.

Preferably, an additional etching process may be performed to roughen the plurality of holes 110H" before forming a material layer for forming the plurality of patterns 120". The additional etching process may be, for example, a wet etching process.

Each of the plurality of holes 110H" may have a roughened circular shape when viewed from above. For example, each of the plurality of holes 110H" may have a star-like shape when viewed from above.

Each of the patterns 120" may have a roughened ring shape when viewed from above. For example, each of the patterns 120" may have a hollow star-like shape when viewed from above.

Each of the plurality of energy source patterns 130" may have a roughened circular shape when viewed from above. For example, each of the plurality of energy source patterns 130" may have a star-like shape when viewed from above.

An interface between the substrate 110 and the plurality of patterns 120" may be roughened. An interface between the plurality of patterns 120" and the plurality of energy source patterns 130" may be roughened.

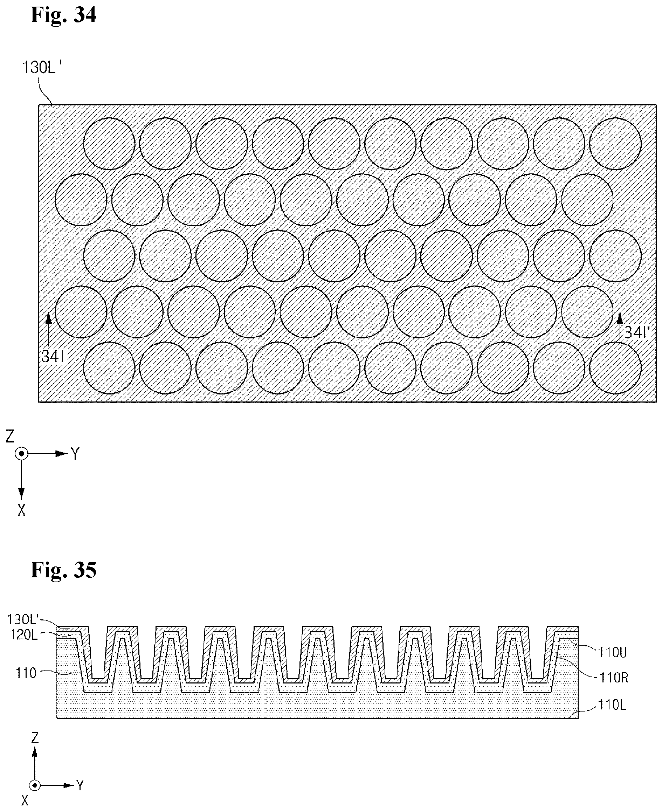

FIG. 34 is a plan view for describing a manufacturing method of a unit battery layer of an integrated isotope battery according to the present invention.

FIG. 35 is a cross-sectional view taken along line 34I-34I' of FIG. 34.

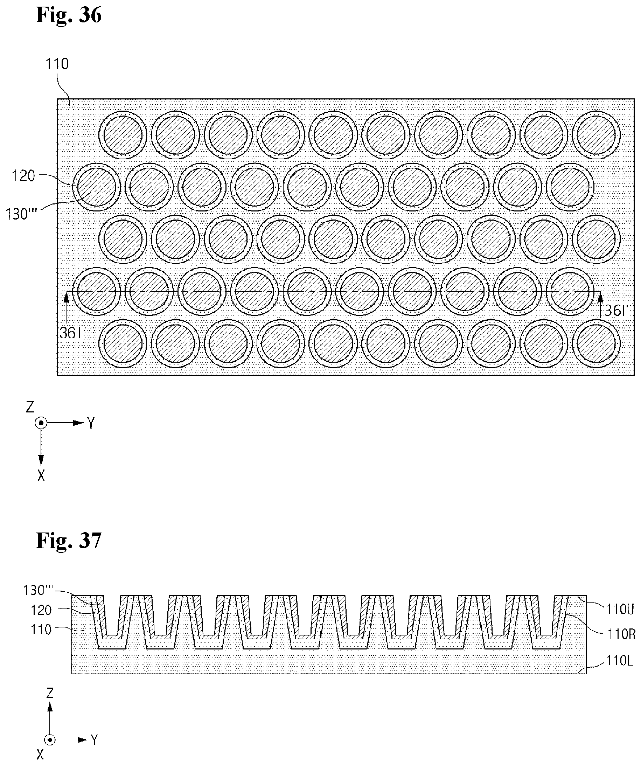

FIG. 36 is a plan view for describing a manufacturing method of a unit battery layer of an integrated isotope battery according to the present invention.

FIG. 37 is a cross-sectional view taken along line 36I-36I' of FIG. 36.

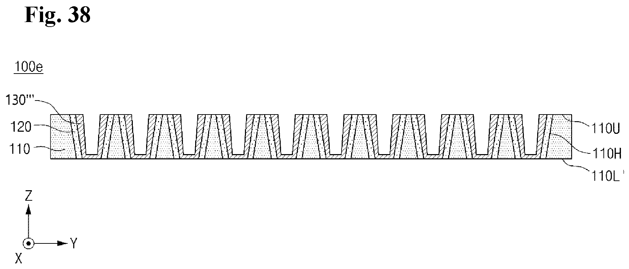

FIG. 38 is a cross-sectional view for describing a manufacturing method of a unit battery layer of an integrated isotope battery according to the present invention. More specifically, FIG. 38 illustrates a part corresponding to FIG. 37.

Referring to FIGS. 34 and 35, a substrate 110 having a layer 120L formed thereon is provided and an energy source layer 130L' may be formed on the top major surface 110U of the substrate 110, to be correspondent to step P140 in Fig. 1. The energy source layer 130L' may partially fill a plurality of recesses 110R leaving a certain volume/space of the recesses unfilled, unlike the energy source layer 130L which fills up the plurality of recesses 110R. The energy source layer 130L' may have a uniform thickness. The energy source layer 130L' may have a conformal shape with the underlying structure.

Next, referring to FIGS. 36 and 37, a first CMP process may be performed on the structure resultant from the previous step, to be correspondent to step P150 in Fig. 1. By the first CMP process, the energy source layer 130L' may be converted into a plurality of energy source patterns 130"', separated from each other. A plurality of patterns 120 are substantially the same as those described above with reference to FIGS. 10 and 11 and thus redundant description thereof is omitted here.

Thereafter, referring to FIGS. 36 and 38, a second CMP process may be performed on the second or bottom major surface 110L of the substrate 110, to be correspondent to step P160 in Fig. 1. The plurality of energy source patterns 130‴ may be an end point of the second CMP process. By the second CMP process, an integrated battery 100e including the substrate 110, the plurality of patterns 120, and the plurality of energy source patterns 130‴ may be provided. The plurality of energy source patterns 130‴ may have a cup shape, leaving a certain volume/space of the recesses unfilled. Optionally, additional filling patterns may further be provided to fill up the space remaining in the plurality of recesses.

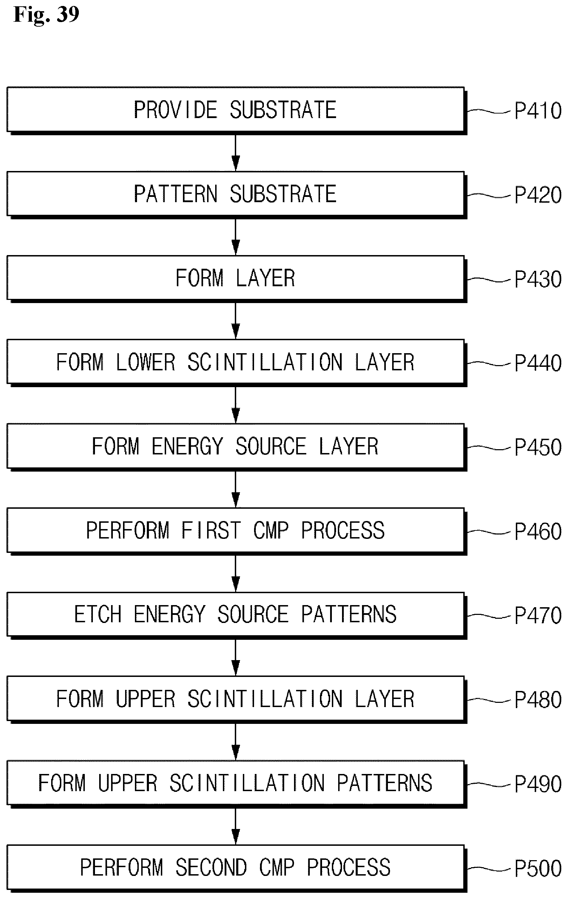

FIG. 39 is a flowchart of a manufacturing method a unit battery layer of an integrated isotope battery according to the present invention.

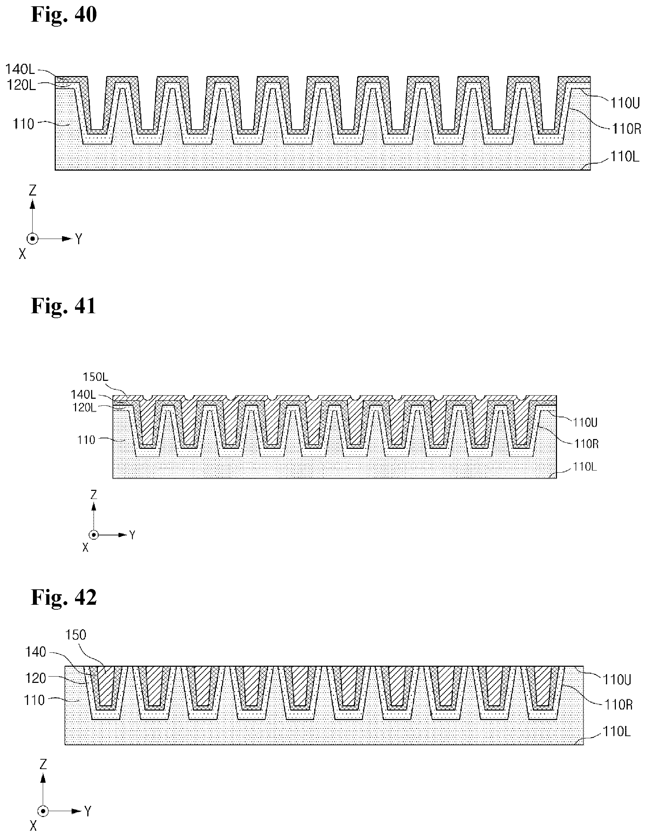

FIGS. 40 to 45 are cross-sectional views for describing a manufacturing method of a unit battery layer of an integrated isotope battery according to the present invention.

Referring to FIGS. 39 and 40, providing a substrate 110 in step P410 is substantially the same as the step P110 in Fig. 1. Patterning the substrate 110 in step P420 is substantially the same as the step P120 in Fig. 1 Forming a layer 120L in step P430 is substantially the same as the step P130 in Fig. 1. The shape and arrangement of the recesses 110R may be the same as any one of FIG. 4, 26, 28, 30, or 32.

Next, in step P440, a lower scintillation layer 140L may be formed. The lower scintillation layer 140L may be formed by a deposition process such as CVD. The lower scintillation layer 140L may have a uniform thickness. The lower scintillation layer 140L may have a conformal shape with the underlying structure. The lower scintillation layer 140L may be configured to emit photons in response to high-energy radiation. The scintillation layer 140L may include at least one of Ba₂Ca(BO₃)₂, BaHfO₃, BaI₂:Ce, BeO, BaF₂, BaMgF₄, Cs₂LiLuCi₆:Ce, K₂YF₅, KCaF₃ or YI₃:Ce but is not limited thereto. Various examples of the lower scintillation layer 140L are disclosed at https://scintillator.lbl.gov/inorganic-scintillator-library/.

Next, referring to FIGS. 39 and 41, in step P450, an energy source layer 150L may be formed. The energy source layer 150L may be formed to fill up the recesses 110R. The energy source layer 150L may be formed by evaporation, sputtering, CVD, electroplating, or electroless plating. When the energy source layer 150L is formed by electroplating or electroless plating, a seed layer may be formed between the energy source layer 150L and the lower scintillation layer 140L.

The energy source layer 150L may emit only alpha rays, or may include a radioactive isotope that emits radiation, such as beta rays or gamma rays, other than alpha rays. The energy source layer 150L may include at least one of neodymium-144 (¹⁴⁴Nd), samarium-147 (¹⁴⁷Sm), terbium-158 (¹⁵⁸Tb), tellurium-104 (¹⁰⁴Te), bismuth-212 (²¹²Bi), astatine-210 (²¹⁰At), astatine-211 (²¹¹At), radon-222 (²²²Rn), francium-223 (²²³Fr), radium-224 (²²⁴Ra), radium-226 (²²⁶Ra), actinium-225 (²²⁵Ac), actinium-227 (²²⁷Ac), thorium-228 (²²⁸Th), thorium-230 (²³⁰Th), thorium-232 (²³²Th), protactinium-231(²³¹Pa), uranium-234 (²³⁴U), uranium-235 (²³⁵U), uranium-238 (²³⁸U), neptunium-237 (²³⁷Np), plutonium-238 (²³⁸Pu), plutonium-239 (²³⁹Pu), plutonium-240 (²⁴⁰Pu), plutonium-241 (²⁴¹Pu), americium-241 (²⁴¹Am), americium-243 (²⁴³Am), curium-242 (²⁴²Cm), curium-243 (²⁴³Cm), curium-244 (²⁴⁴Cm), curium-245 (²⁴⁵Cm), berkelium-247 (²⁴⁷Bk), berkelium-249 (²⁴⁹Bk), californium-249 (²⁴⁹Cf), californium-250 (²⁵⁰Cf), californium-251 (²⁵¹Cf), californium-252 (²⁵²Cf), einsteinium-252 (²⁵²Es), einsteinium-253 (²⁵³Es), fermium-257 (²⁵⁷Fm), mandellevium-258 (²⁵⁸Md), nobelium-255 (²⁵⁵No), laurencium-260 (²⁶⁰Lr), polonium-208 (²⁰⁸Po), polonium-210 (²¹⁰Po), or polonium-212 (²¹²Po).

Next referring to FIGS. 39, 41 and 42, in step P460, a first CMP process may be performed. The top surface 110U of the substrate 110 may be an end point of the first CMP process.

By the first CMP process, the layer 120L may be divided into a plurality of patterns 120. By the first CMP process, the lower scintillation layer 140L may be divided into a plurality of lower scintillation patterns 140. By the first CMP process, the energy source layer 150L may be divided into a plurality of energy source patterns 150. An upper surface of each of the plurality of patterns 120, an upper surface of each of the plurality of lower scintillation patterns 140, and an upper surface of each of the plurality of energy source patterns 150 may be coplanar with the top surface 110U of the substrate 110.

Next, referring to FIGS. 39, 42, and 43, in step P470, the plurality of energy source patterns 150 may be etched. The plurality of energy source patterns 150 may be etched using an etching mask EM. The etching mask EM may expose the energy source patterns 150 and cover the plurality of patterns 120 and the plurality of lower scintillation patterns 140.

The plurality of energy source patterns 150 may be etched by anisotropic dry etching. The plurality of energy source patterns 150 may be etched by a plasma-based process such as RIE, but are not limited thereto. The plurality of energy source patterns 150 may be partially removed by an etching process of step P470. Accordingly, the upper surface of each of the plurality of energy source patterns 150 may be at a lower level than the upper surface of each of the plurality of patterns 120, the upper surface of each of the plurality of lower scintillation patterns 140, and the top surface 110U of the substrate 110. The upper surface of each of the plurality of energy source patterns 150 may be between the upper surface 110U of the substrate 110 and the lower surface 110L of the substrate 110. After etching the plurality of energy source patterns 150, the etching mask EM may be removed by ashing, O₂ plasma treatment, or wet strip.

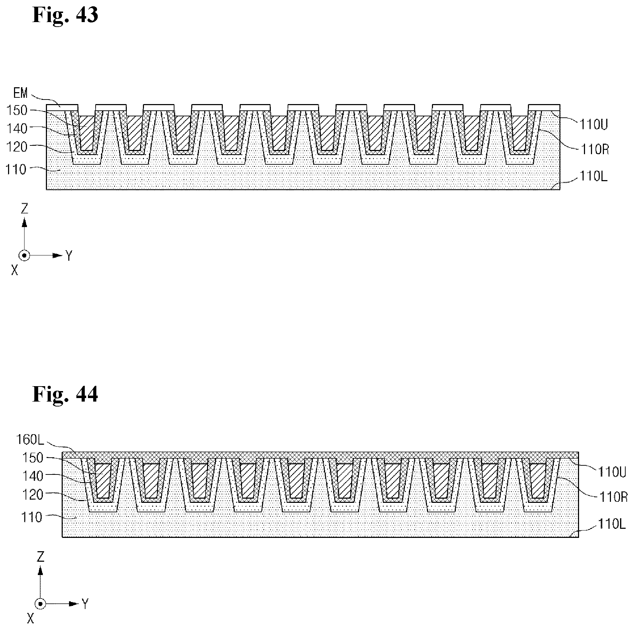

Next, referring to FIGS. 39 and 44, in step P480, an upper scintillation layer 160L may be formed. The upper scintillation layer 160L may be formed by a deposition process such as CVD. The upper scintillation layer 160L may have a uniform thickness. The upper scintillation layer 160L may have a conformal shape. The upper scintillation layer 160L may be configured to emit photons in response to high-energy radiation. The upper scintillation layer 160L may include one of the materials provided herein as examples of the lower scintillation layer 140L (see FIG. 41). The upper scintillation layer 160L may include the same material as the lower scintillation layer 140L but is not limited thereto. The upper scintillation layer 160L may include a material different from that of the lower scintillation layer 140L.

Next, referring to FIGS. 39, 44, and 45, in step P490, a plurality of upper scintillation patterns 160 may be formed. The plurality of upper scintillation patterns 160 may be formed by performing CMP by setting the top surface 110U of the substrate 110 as an end point. The upper scintillation layer 160L may be divided into a plurality of upper scintillation patterns 160 by the CMP.

The plurality of upper scintillation patterns 160 and the plurality of lower scintillation patterns 140 may be formed integrally. Each of the plurality of upper scintillation patterns 160 may be continuous with a corresponding one of the plurality of lower scintillation patterns 140. In this case, there may be no observable interface between the upper scintillation pattern 160 and the lower scintillation pattern.

Alternatively, the plurality of upper scintillation patterns 160 and the plurality of lower scintillation patterns 140 may be distinguished from each other. The plurality of upper scintillation patterns 160 and the plurality of lower scintillation patterns 140 may be separate layers that are distinguished from each other. In this case, there may be an observable interface between the plurality of upper scintillation patterns 160 and the plurality of lower scintillation patterns 140.

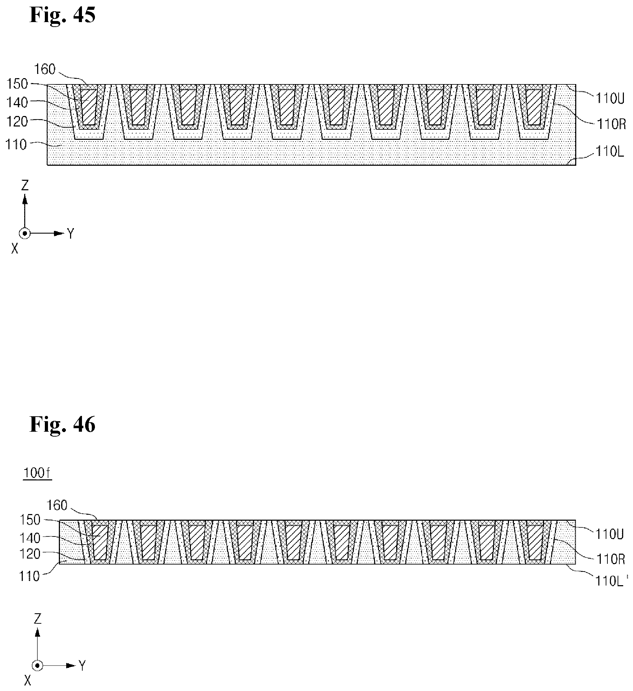

Referring to FIGS. 39 and 46, in step P500, a second CMP process may be performed. The plurality of lower scintillation patterns 140 may be an end point of the second CMP process. By the second CMP process, a unit battery layer 100f of an integrated battery including the substrate 110, the plurality of patterns 120, the plurality of lower scintillation patterns 140, the plurality of energy source patterns 150, and the plurality of upper scintillation patterns 160 may be provided.

By carrying out the second CMP process, the plurality of recesses 110R of FIG. 45 may become a plurality of holes 110H extending from the top surface 110U of the substrate 110 to a new lower surface 110L' of the substrate 110. That is, each of the plurality of holes 110H may extend through the entire thickness of the substrate 110. Each of the plurality of patterns 120 may be in a corresponding one of the plurality of holes 110H. Each of the plurality of lower scintillation patterns 140 may be in a corresponding one of the plurality of holes 110H. Each of the plurality of energy source patterns 150 may be in a corresponding one of the plurality of holes 110H. Each of the plurality of upper scintillation patterns 160 may be in a corresponding one of the plurality of holes 110H.

Each of the plurality of energy source patterns 150 may be surrounded by a corresponding one of the plurality of lower scintillation patterns 140 and a corresponding one of the plurality of upper scintillation patterns 160. Accordingly, high-energy radiation emitted from the plurality of energy source patterns 150 may be converted into photons by the plurality of lower scintillation patterns 140 and the plurality of upper scintillation patterns 160, to thereby prevent the substrate 110 and the plurality of patterns 120 from being damaged due to the high-energy radiation.

Each of the plurality of energy source patterns 150 may have a tapered shape, having a decreasing width as it gets lower. The plurality of energy source patterns 150 may be spaced apart from the plurality of patterns 120. Each of the plurality of lower scintillation patterns 140 may be between a corresponding one of the plurality of energy source patterns 150 and a corresponding one of the plurality of patterns 120. Each of the plurality of upper scintillation patterns 140 may be positioned on top of a corresponding one of the plurality of energy source patterns 150.

The present invention has been described above in more detail with reference to the drawings, the embodiments, etc. However, the configurations illustrated in the drawings or embodiments described in the present disclosure are only exemplary embodiments of the present invention and do not reflect all the technical concept of the present invention and thus it should be understood that various equivalents and modifications that replace the configurations can be made without departing the scope of protection defined by the appended claims.

## Claims

1. An integrated isotope battery comprising at least one unit battery layer (L1, L2), the unit battery layer (L1, L2) including:
a substrate (110) having a first major surface, an opposite second major surface, and a plurality of recesses (110R) formed in the first major surface;
a pattern (120) disposed in the plurality of recesses (110R), wherein the pattern (120) has a conductive type opposite to a conductive type of the substrate, a p-n junction being formed between the substrate (110) and the pattern (120); and
a radioactive radiation source pattern (130) disposed in the plurality of recesses (110R), on the pattern (120), wherein the radioactive radiation source pattern (130) is configured to emit radioactive radiation to an interface between the substrate (110) and the pattern (120),
wherein the radioactive radiation source pattern (130) has at least a portion with a tapered shape, gradually becoming thinner towards the second major surface.

2. The integrated isotope battery of claim 1, wherein the recess (110R) has at least a portion with a tapered shape, gradually becoming thinner towards the second major surface of the substate (110), being conformal with the at least a portion of the radioactive radiation source pattern (130).

3. The integrated isotope battery of any one of the preceding claims, wherein the plurality of radioactive radiation source pattern (130) has a second portion with an oppositely tapered shape, gradually becoming wider towards the second major surface of the substrate (110), such that the radioactive radiation source pattern (130) has a narrow middle.

4. The integrated isotope battery of claim 3, insofar as dependent upon claim 2, wherein the recess (110R) has a second portion with an oppositely tapered shape, gradually becoming wider towards the second major surface of the substrate (110), being conformal with the second portion of the radioactive radiation source pattern (130).

5. The integrated isotope battery of any one of the preceding claims, wherein the pattern (120) has a uniform width throughout the thickness of the substrate (110).

6. The integrated isotope battery of any one of the preceding claims, wherein the plurality of recesses (110R) extend entirely through the substrate (110) from the first major surface till the second major surface.

7. The integrated isotope battery of any one of the preceding claims, wherein the plurality of recesses (110R) are arranged within the first major surface in a honeycomb structure.

8. The integrated isotope battery of any one of the preceding claims, wherein the plurality of recesses (110R) are arranged within the first major surface forming multiple rows aligned in a staggering manner with respect to one another.

9. The integrated isotope battery of any one of claims 1 to 6, wherein the plurality of recesses (110R) are arranged within the first major surface in a matrix.

10. The integrated isotope battery of any one of claims 1 to 6, wherein each of the plurality of recesses (110R) has a longitudinal shape with an extension along the first major surface.

11. The integrated isotope battery of any one of the preceding claims, wherein each of the plurality of recesses (110R) has a roughened circumference.

12. The integrated isotope battery of any one of the preceding claims, wherein each of the plurality of recesses (110R) has a star-like circumference within the first major surface of the substrate.

13. The integrated isotope battery of any one of the preceding claims, wherein an interface between the substrate (110) and the pattern (120) is roughened.

14. The integrated isotope battery of any one of the preceding claims, wherein an interface between the pattern (120) and the radioactive radiation source pattern (130) is roughened.

15. The integrated isotope battery of any one of the preceding claims, wherein the radioactive radiation source pattern is configured to emit beta rays and/or alpha rays.

16. The integrated isotope battery of any one of the preceding claims, wherein the unit battery layer (L1, L2) further comprises: a scintillation pattern disposed in the plurality of recesses (110R) for emitting photons in response to alpha rays.

17. The integrated isotope battery of claim 16, wherein the scintillation pattern includes: a lower scintillation pattern (140) disposed in-between the pattern (120) and the radioactive radiation source pattern (130); and an upper scintillation pattern (160) disposed on top of the radioactive radiation source pattern (130) to cover it.

18. The integrated isotope battery of claim 17, wherein the upper scintillation pattern (160) forms a continuous layer with the lower scintillation pattern (140).

19. The integrated isotope battery of any one of the preceding claims, comprising:
two or more of the unit battery layer (L1, L2); and
an insulating layer (361) interposed between the two or more unit battery layers (L1, L2).

20. The integrated isotope battery of claim 19, further comprising a plurality of vias (371) electrically connecting the two or more unit battery layers (L1, L2) through the insulating layer (361).

21. The integrated isotope battery of claim 20, wherein the plurality of vias connect a substrate (110) of one of the two or more unit battery layers (L1, L2) directly stacked on top of the other with a layer (120L) of the other of the two or more unit battery layers (L1, L2).

22. The integrated isotope battery of any one of claims 19 to 21, wherein the two or more unit battery layers (L1, L2) are connected in series.

23. The integrated isotope battery of any one of claims 19 to 22, wherein the two or more unit battery layers (L1, L2) are configured such that their respective substrates (110) have an identical conductive type and their respective layers (120L) have an identical conductive type.

24. The integrated isotope battery of any one of claims 19 to 21, wherein the two or more unit battery layers (L1, L2) are connected in parallel.

25. The integrated isotope battery of any one of claims 19 to 21 or 24, wherein the two unit battery layers (L1, L2) stacked on top of the other are configured such that their respective substrates (110) have opposite conductive types and their respective layers (120L) have opposite conductive types.

26. The integrated isotope battery of any one of the preceding claims, further comprising a core layer (LC) including a peripheral transistor.

27. The integrated isotope battery of claim 26, wherein the at least one unit battery layer (L1, L2) is arranged on top of the core layer (LC).

28. The integrated isotope battery of claim 26 or 27, wherein the peripheral transistor includes a voltage regulator configured to adjust output voltage of the at least one unit battery layers (L1, L2).
